(19) **Europäisches Patentamt / European Patent Office / Office européen des brevets**

(11) **EP 4 489 276 A1**

(12) **EUROPEAN PATENT APPLICATION**
published in accordance with Art. 153(4) EPC

(43) Date of publication:
**08.01.2025 Bulletin 2025/02**

(21) Application number: **22929693.4**

(22) Date of filing: **01.03.2022**

(51) International Patent Classification (IPC):
**H02M 1/12** (2006.01)   **H02M 7/48** (2007.01)

(52) Cooperative Patent Classification (CPC):
**H02M 1/12; H02M 7/48**

(86) International application number:
**PCT/JP2022/008506**

(87) International publication number:
**WO 2023/166544 (07.09.2023 Gazette 2023/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **MITSUBISHI ELECTRIC CORPORATION**
  **Chiyoda-ku**
  **Tokyo 100-8310 (JP)**
• **Mitsubishi Electric Engineering Company Limited**
  **Chiyoda-ku, Tokyo 102-0073 (JP)**

(72) Inventors:
• **FUJITA, Yuki**
  **Tokyo 100-8310 (JP)**
• **FURUSHO, Yasuaki**
  **Tokyo 100-8310 (JP)**
• **NAGASAWA, Shinobu**
  **Tokyo 100-8310 (JP)**
• **ICHINOSE, Hiroyuki**
  **Tokyo 102-0073 (JP)**

(74) Representative: **Meissner Bolte Partnerschaft mbB**
**Patentanwälte Rechtsanwälte**
**Postfach 86 06 24**
**81633 München (DE)**

(54) **NOISE FILTER**

(57)     A noise filter (50) includes: a noise detector (7) which detects voltage due to electromagnetic noise generated by a power converter (2) and outputs adjusted voltage (Vd) obtained by adjusting the detected voltage; a compensation signal applicator (75) which superimposes compensation voltage (Vcom) having a polarity opposite to the voltage due to electromagnetic noise, on an output or an input of the power converter (2) via a transformer (11); and an injection voltage generator 30 which generates, on the basis of the adjusted voltage (Vd), first output voltage (Vo1) and second output voltage (Vo2) having a polarity opposite thereto, for generating injection voltage (Vinj) between one end and another and of a primary-side winding (ml) of the transformer (11), and outputs the first output voltage and the second output voltage to the one end and the other end, respectively.

FIG. 1

EP 4 489 276 A1

## Description

### TECHNICAL FIELD

The present invention relates to a noise filter.

### BACKGROUND ART

In recent years, in a power conversion device such as a voltage-type pulse width modulation (PWM) inverter, along with development of power semiconductor elements, a carrier frequency is being increased to a higher frequency. However, as the carrier frequency is increased to a higher frequency, electromagnetic interference due to voltage of electromagnetic noise such as common mode voltage which occurs in switching operation of a power semiconductor element becomes a problem. In order to cope with this problem, it is proposed that voltage (cancellation voltage) for canceling out common mode voltage generated by a power conversion device is superimposed using a common mode transformer, to reduce leakage current (i.e., common mode current) flowing to the ground due to the common mode voltage (for example, Patent Document 1).

A conductive noise filter in Patent Document 1 includes: a common mode transformer having secondary windings, i.e., secondary-side windings, provided on three-phase cables connecting an inverter and an AC power supply; a push-pull-type emitter follower circuit connected to a primary winding, i.e., a primary-side winding, of the common mode transformer; three grounded capacitors for detecting common mode voltage; voltage division capacitors for dividing the detected common mode voltage; and an operational amplifier which amplifies the divided common mode voltage and outputs the amplified voltage to the push-pull-type emitter follower circuit.

The common mode transformer induces cancellation voltage having the same magnitude as and a polarity opposite to the detected common mode voltage, on the secondary-side windings. In the conductive noise filter in Patent Document 1, the detected common mode voltage is divided and the cancellation voltage is induced on the secondary-side windings in accordance with the turns ratio of the primary-side winding and the secondary-side windings of the common mode transformer, whereby voltage outputted to the primary-side winding of the common mode transformer is reduced. Thus, the withstand voltages of active elements used in the emitter follower circuit and the operational amplifier can be reduced.

### CITATION LIST

### PATENT DOCUMENT

Patent Document 1: Japanese Patent JP 5 263 663 B2

### SUMMARY OF THE INVENTION

### PROBLEM TO BE SOLVED BY THE INVENTION

However, in the conductive noise filter in Patent Document 1, the cancellation voltage lower than the common mode voltage generated on the three-phase cables is induced on the secondary-side windings. In order to enhance the noise reduction effect, greater cancellation voltage or cancellation current, i.e., compensation voltage or compensation current, needs to be generated on the secondary-side windings. For this purpose, it is necessary to increase the turns ratio of the common mode transformer or increase voltages of the emitter follower circuit and the operational amplifier. In a case of increasing the turns ratio of the common mode transformer, the numbers of turns of the secondary-side windings for three phases are increased, so that the size of the common mode transformer increases. On the other hand, in a case of increasing voltages of the emitter follower circuit and the operational amplifier, the emitter follower circuit and the operational amplifier having high voltage generation capabilities, and a high-voltage power supply for driving them, are needed. This results in size increase and weight increase of the entire device.

An object of the technology according to the present invention is to provide a noise filter that can have an enhanced noise reduction effect while having a reduced size and a reduced weight.

### MEANS TO SOLVE THE PROBLEM

A noise filter according to one aspect of the present invention is a noise filter that reduces voltage or current of electromagnetic noise generated by a power converter performing power conversion through switching operation of a semiconductor element. The noise filter includes: a noise detector which detects voltage based on the electromagnetic noise generated by the power converter and outputs adjusted voltage obtained by adjusting the voltage based on the electromagnetic noise; a compensation signal applicator which superimposes compensation voltage having a polarity opposite to the voltage based on the electromagnetic noise, on an output or an input of the power converter via a transformer; and an injection voltage generator which generates, on the basis of the adjusted voltage, first output voltage and second output voltage having a polarity opposite to the first output voltage, for generating injection voltage between one end and another end of a primary-side winding of the transformer, and which outputs the first output voltage to the one end of the primary-side winding of the transformer and outputs the second output voltage to the other end of the primary-side winding of the transformer. The injection voltage generator generates the first output voltage and the second output voltage for generating the injection voltage so that a difference between the compensation voltage superimposed by the compensation signal applicator and the voltage based on the electromagnetic noise becomes an allowable value or less.

EFFECT OF THE INVENTION

In the noise filter according to one aspect of the present invention, the first output voltage and the second output voltage having a polarity opposite to the first output voltage are respectively applied to both ends of the primary-side winding of the transformer of the compensation signal applicator, whereby the compensation voltage is superimposed on the output or the input of the power converter on the basis of the injection voltage having the same polarity as the first output voltage and greater than the first output voltage. Thus, the noise filter can have an enhanced noise reduction effect while having a reduced size and a reduced weight.

BRIEF DESCRIPTION OF THE DRAWINGS

FIG. 1 shows the configuration of a first noise filter and an electric motor driving system according to Embodiment 1.
FIG. 2 shows the configuration of a power converter shown in FIG. 1.
FIG. 3 shows the configuration of a signal adjustment circuit shown in FIG. 1.
FIG. 4 shows a first example of an injection waveform generator shown in FIG. 1.
FIG. 5 shows a second example of the injection waveform generator shown in FIG. 1.
FIG. 6 shows a third example of the injection waveform generator shown in FIG. 1.
FIG. 7 shows the configuration of a second noise filter and an electric motor driving system according to Embodiment 1.
FIG. 8 shows the configuration of a third noise filter and an electric motor driving system according to Embodiment 1
FIG. 9 shows a core of the noise filter according to Embodiment 1.
FIG. 10 shows the configuration of a fourth noise filter and an electric motor driving system according to Embodiment 1.
FIG. 11 shows the configuration of a fifth noise filter and an electric motor driving system according to Embodiment 1.
FIG. 12 shows the configuration of a signal adjustment circuit shown in FIG. 11.
FIG. 13 shows the configuration of a first noise filter and an electric motor driving system according to Embodiment 2.
FIG. 14 shows the configuration of a second noise filter and an electric motor driving system according to Embodiment 2.

FIG. 15 shows the configuration of a third noise filter and an electric motor driving system according to Embodiment 2.
FIG. 16 shows a first example of an injection waveform generator shown in FIG. 13.
FIG. 17 shows a second example of the injection waveform generator shown in FIG. 13.
FIG. 18 shows a third example of the injection waveform generator shown in FIG. 13.
FIG. 19 shows the configuration of a first noise filter and an electric motor driving system according to Embodiment 3.
FIG. 20 shows the configuration of a second noise filter and an electric motor driving system according to Embodiment 3.
FIG. 21 shows the configuration of a third noise filter and an electric motor driving system according to Embodiment 3.
FIG. 22 shows the configuration of a first noise filter and an electric motor driving system according to Embodiment 4.
FIG. 23 shows the configuration of a second noise filter and an electric motor driving system according to Embodiment 4.
FIG. 24 shows the configuration of a third noise filter and an electric motor driving system according to Embodiment 4.
FIG. 25 shows the configuration of a first noise filter and an electric motor driving system according to Embodiment 5.
FIG. 26 shows the configuration of a second noise filter and an electric motor driving system according to Embodiment 5.
FIG. 27 shows the configuration of a third noise filter and an electric motor driving system according to Embodiment 5.
FIG. 28 shows the configuration of a first noise filter and an electric motor driving system according to Embodiment 6.
FIG. 29 shows the configuration of a second noise filter and an electric motor driving system according to Embodiment 6.
FIG. 30 shows the configuration of a third noise filter and an electric motor driving system according to Embodiment 6.
FIG. 31 shows the configuration of a first noise filter and an electric motor driving system according to Embodiment 7.
FIG. 32 shows an injection waveform generator shown in FIG. 31.
FIG. 33 shows the configuration of a second noise filter according to Embodiment 7.
FIG. 34 shows an injection waveform generator shown in FIG. 33.
FIG. 35 shows the configuration of a third noise filter according to Embodiment 7.
FIG. 36 shows the configuration of a fourth noise filter according to Embodiment 7.

FIG. 37 shows the configuration of a fifth noise filter according to Embodiment 7.

FIG. 38 shows the configuration of a sixth noise filter according to Embodiment 7.

FIG. 39 shows the configuration of a seventh noise filter according to Embodiment 7.

DESCRIPTION OF EMBODIMENTS

A noise filter and an electric motor driving system will be described with reference to the drawings. In the drawings, the same or corresponding parts are denoted by the same reference characters, to give description.

Embodiment 1

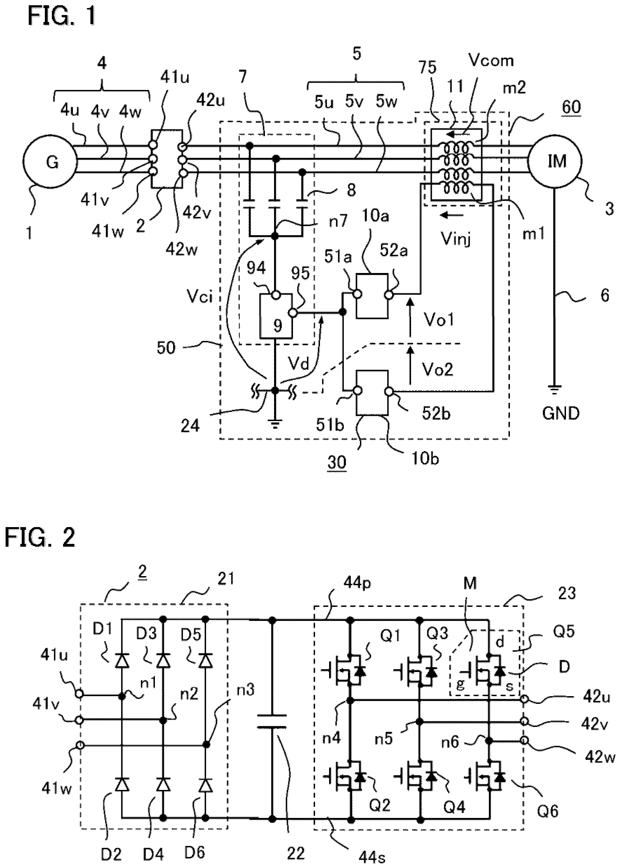

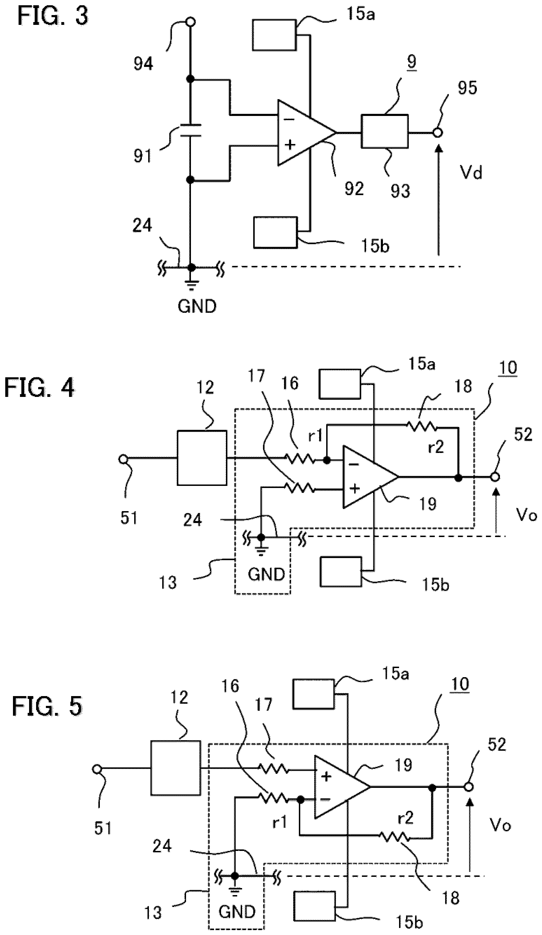

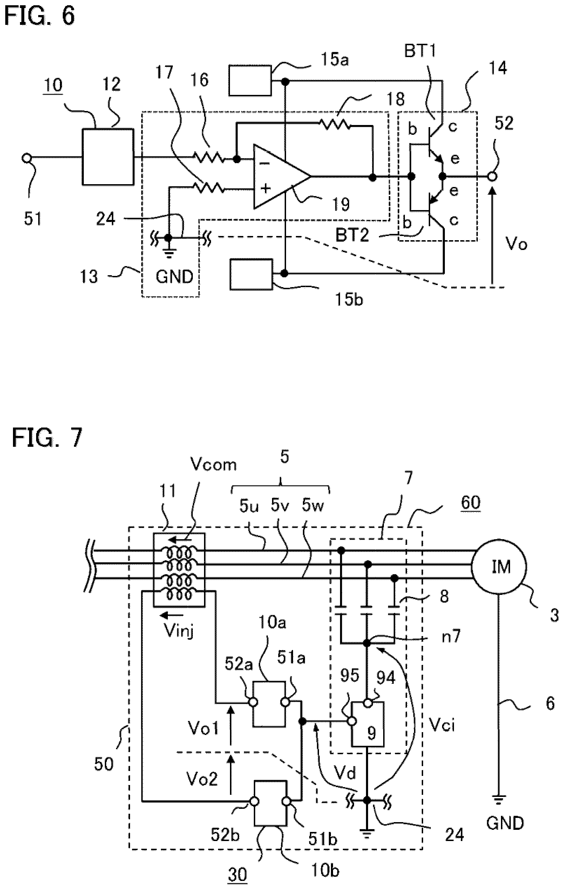

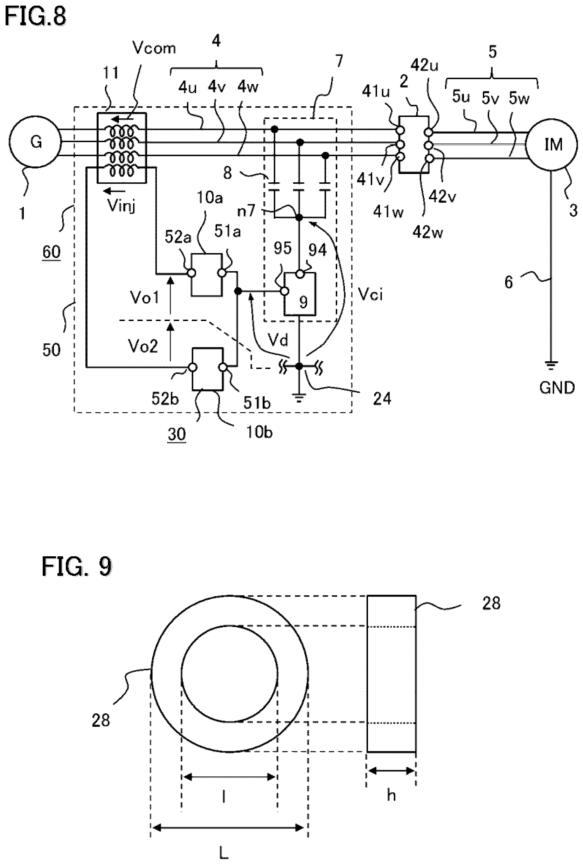

FIG. 1 shows the configuration of a first noise filter and an electric motor driving system according to Embodiment 1, and FIG. 2 shows the configuration of a power converter shown in FIG. 1. FIG. 3 shows the configuration of a signal adjustment circuit included in a noise detector shown in FIG. 1. FIG. 4 shows a first example of an injection waveform generator shown in FIG. 1, FIG. 5 shows a second example of the injection waveform generator shown in FIG. 1, and FIG. 6 shows a third example of the injection waveform generator shown in FIG. 1. FIG. 7 shows the configuration of a second noise filter and an electric motor driving system according to Embodiment 1, and FIG. 8 shows the configuration of a third noise filter and an electric motor driving system according to Embodiment 1.

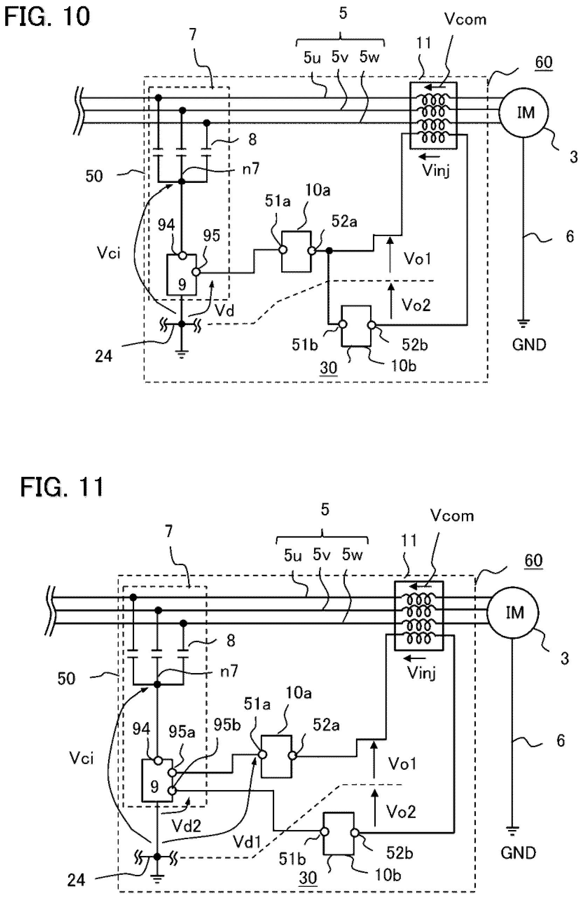

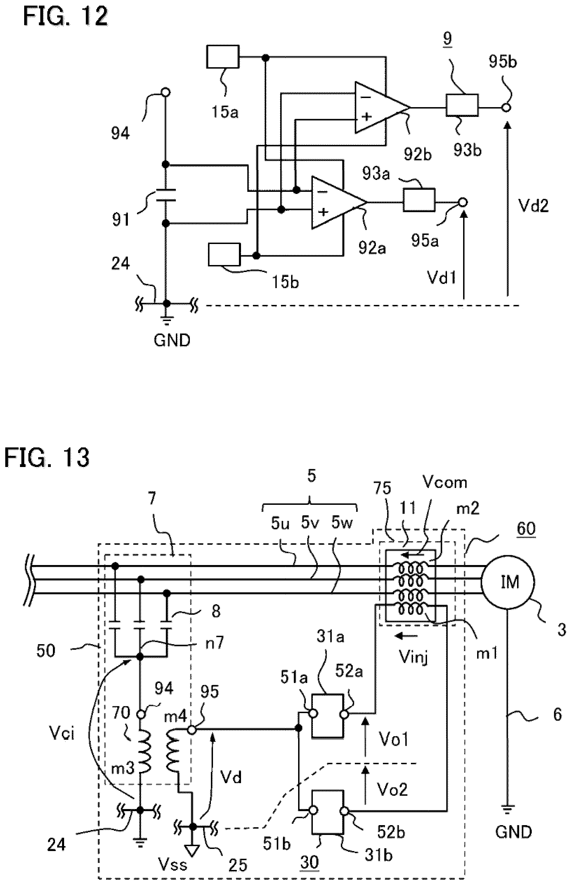

FIG. 9 shows a core of the noise filter according to Embodiment 1. FIG. 10 shows the configuration of a fourth noise filter and an electric motor driving system according to Embodiment 1, and FIG. 11 shows a fifth noise filter and an electric motor driving system according to Embodiment 1. FIG. 12 shows the configuration of a signal adjustment circuit shown in FIG. 11. A noise filter 50 of Embodiment 1 is applicable to an electric motor driving system 60 which is a system for controlling an induction electric motor 3 which is an inductive load by a power converter 2 such as a voltage-type PWM inverter in which a plurality of semiconductor elements perform switching operations.

The electric motor driving system 60 includes: an AC power supply 1 such as a power grid or a stand-alone voltage source; a power converter 2 which converts AC power of the AC power supply 1 to DC power and converts the DC power to AC power; three-phase power lines 4 connecting the AC power supply 1 and the power converter 2; three-phase power lines 5 connecting the power converter 2 and an induction electric motor 3; and the noise filter 50. The induction electric motor 3 is grounded by a ground line 6. The potential of a ground GND, i.e., a ground potential, serves as a reference potential for the noise filter 50. The three-phase power lines 4 include a three-phase power line 4u for u phase, a three-phase power line 4v for v phase, and a three-phase power line 4w for w phase. The three-phase power lines 5 include a three-phase power line 5u for u phase, a three-phase power line 5v for v phase, and a three-phase power line 5w for w phase.

The noise filter 50 reduces voltage or current of electromagnetic noise generated by the power converter 2 performing power conversion through switching operations of semiconductor elements. The noise filter 50 includes: a noise detector 7 which detects voltage of electromagnetic noise generated by the power converter 2 and outputs adjusted voltage Vd obtained by adjusting the voltage of the electromagnetic noise; a compensation signal applicator 75 which superimposes compensation voltage Vcom having a polarity opposite to voltage of electromagnetic noise on the output or the input of the power converter 2 via a transformer 11 having a primary-side winding m1 on the primary side and secondary-side windings m2 on the secondary side; and an injection voltage generator 30 which generates, on the basis of the adjusted voltage Vd, output voltage Vo1 for first and output voltage Vo2 for second which has a polarity opposite to the output voltage Vo1 for first, for generating injection voltage Vinj between one end and another end of the primary-side winding m1 of the transformer 11, and which outputs the output voltage Vo1 for first to the one end of the primary-side winding m1 of the transformer 11 and outputs the output voltage Vo2 for second to the other end of the primary-side winding m1 of the transformer 11.

The voltage of the electromagnetic noise is, for example, common mode voltage Vci. The current of the electromagnetic noise is, for example, common mode current flowing by application of the common mode voltage Vci on a common mode path. In Embodiment 1, a case where the noise detector 7 detects voltage of electromagnetic noise as voltage based on electromagnetic noise will be described. A case where the noise detector 7 detects voltage proportional to current of electromagnetic noise, i.e., common mode current, as voltage based on electromagnetic noise will be described in Embodiment 5. The injection voltage generator 30 includes injection waveform generators 10a, 10b. The compensation signal applicator 75 includes the transformer 11. The output voltage Vo1 for first and the output voltage Vo2 for second may be referred to as first output voltage Vo1 and second output voltage Vo2, respectively.

The power converter 2 includes a rectifier circuit 21 composed of semiconductor elements, a capacitor 22 which is a power storage element for storing DC power, and an inverter circuit 23 which is composed of semiconductor elements and converts DC power to AC power. The rectifier circuit 21 is, for example, a rectification circuit, and includes six diodes D1, D2, D3, D4, D5, D6. The inverter circuit 23 includes six semiconductor elements Q1, Q2, Q3, Q4, Q5, Q6. Three-phase power lines 4u, 4v, 4w have ends connected to the AC power supply 1 and other ends connected to AC input terminals 41u, 41v, 41w of the power converter 2. Three-phase power lines 5u, 5v, 5w have ends connected to the induction electric motor 3 and other ends connected to AC output terminals 42u, 42v, 42w of the power converter 2.

In the rectifier circuit 21, a first series unit of diodes D1, D2 connected in series, a second series unit of diodes D3, D4 connected in series, and a third series unit of diodes D5, D6 connected in series, are provided between a high-potential-side line 44p and a low-potential-side line 44s. A connection point n1 between the diode D1 and the diode D2 is connected to the AC input terminal 41u. A connection point n2 between the diode D3 and the diode D4 is connected to the AC input terminal 41v, and a connection point n3 between the diode D5 and the diode D6 is connected to the AC input terminal 41w. The capacitor 22 is connected between the high-potential-side line 44p and the low-potential-side line 44s.

In the inverter circuit 23, a fourth series unit of semiconductor elements Q1, Q2 connected in series, a fifth series unit of semiconductor elements Q3, Q4 connected in series, and a sixth series unit of semiconductor elements Q5, Q6 connected in series, are provided between the high-potential-side line 44p and the low-potential-side line 44s. A connection point n4 between the semiconductor element Q1 and the semiconductor element Q2 is connected to the AC output terminal 42u. A connection point n5 between the semiconductor element Q3 and the semiconductor element Q4 is connected to the AC output terminal 42v, and a connection point n6 between the semiconductor element Q5 and the semiconductor element Q6 is connected to the AC output terminal 42w.

As the semiconductor elements Q1, Q2, Q3, Q4, Q5, Q6, for example, power semiconductor elements such as a metal-oxide-semiconductor field-effect transistor (MOSFET) or an insulated gate bipolar transistor (IGBT) are used. In FIG. 2, MOSFETs are used as an example. The semiconductor elements Q1, Q2, Q3, Q4, Q5, Q6 each include a MOS transistor M and a diode D. The diode D may be an element separate from the MOS transistor M, or may be a parasitic diode. Drains d of the semiconductor elements Q1, Q3, Q5 are connected to the high-potential-side line 44p, and sources s of the semiconductor elements Q2, Q4, Q6 are connected to the low-potential-side line 44s.

A source s of the semiconductor element Q1 and a drain d of the semiconductor element Q2 are connected to each other, a source s of the semiconductor element Q3 and a drain d of the semiconductor element Q4 are connected to each other, and a source s of the semiconductor element Q5 and a drain d of the semiconductor element Q6 are connected to each other. Control signals are inputted from a control circuit (not shown) to gates g of the semiconductor elements Q1, Q2, Q3, Q4, Q5, Q6. In the inverter circuit 23, the semiconductor elements Q1, Q2, Q3, Q4, Q5, Q6 undergo switching on the basis of the control signals from the control circuit, thus converting DC power to AC power.

The noise detector 7 for detecting the common mode voltage Vci includes three capacitors 8 having equal capacitances, and a signal adjustment circuit 9. Ends of the capacitors 8 are connected to the three-phase power lines 5 for the respective phases. Other ends of the capacitors 8 are connected to each other at a connection point n7. The signal adjustment circuit 9 has an input terminal 94 connected to the connection point n7 to which the other ends of the capacitors 8 are connected, and an output terminal 95 connected to input terminals 51a, 51b of the injection waveform generators 10a, 10b. The signal adjustment circuit 9 outputs, as output voltage, the adjusted voltage Vd obtained by performing voltage division, band limitation, or both of them, for the common mode voltage Vci which is input voltage between the input terminal 94 and a line 24 which is a ground line having a ground potential.

The noise detector 7 detects the common mode voltage Vci and outputs the adjusted voltage Vd based on the common mode voltage Vci. Specifically, the noise detector 7 includes the capacitors 8 and the signal adjustment circuit 9 connected in series between the line 24 which is a ground line and the three-phase power lines 5 on the output side of the power converter 2, and the signal adjustment circuit outputs the adjusted voltage Vd on the basis of the common mode voltage Vci which is input voltage inputted via the capacitors 8.

As shown in FIG. 3, the signal adjustment circuit 9 includes a capacitor 91, a differential amplifier 92 connected in parallel to the capacitor 91, a band limiter 93, and control power supplies 15a, 15b, for example. The control power supply 15a supplies positive-side voltage, and the control power supply 15b supplies negative-side voltage. One end of the capacitor 91 and an inverting input terminal (negative-side input terminal) of the differential amplifier 92 are connected to the input terminal 94, and another end of the capacitor 91 and a non-inverting input terminal (positive-side input terminal) of the differential amplifier 92 are connected to the line 24 having the ground potential.

An output of the differential amplifier 92 is connected to the band limiter 93, and an output of the band limiter 93 is outputted as the adjusted voltage Vd from the output terminal 95. The band limiter 93 is configured to allow passage in a target frequency band, and any of a band-pass filter, a low-pass filter, and a high-pass filter may be adopted.

The adjusted voltage Vd is inputted to the input terminals 51a, 51b of the injection waveform generators 10a, 10b. The injection voltage generator 30 includes a first injection waveform generator 10a which generates the first output voltage Vo1 on the basis of the adjusted voltage Vd, and the second injection waveform generator 10b which generates the second output voltage Vo2 on the basis of the adjusted voltage Vd. The injection waveform generators 10a, 10b output, from the output terminals 52a, 52b, the output voltages Vo1, Vo2 which are voltages having undergone band limitation and voltage value amplification on the basis of the inputted adjusted voltage Vd.

The output voltage Vo1 outputted from the output terminal 52a of the injection waveform generator 10a is inputted to one end of the primary-side winding m 1 of the transformer 11. The output voltage Vo2 outputted from the output terminal 52b of the injection waveform generator 10b is inputted to another end of the primary-side winding m1 of the transformer 11. The output voltage Vo1 and the output voltage Vo2 are voltages having the same magnitude and opposite phases. That is, the output voltage Vo1 and the output voltage Vo2 are voltages having the same magnitude and opposite polarities. On the primary-side winding m1 of the transformer 11, a difference between the output voltage Vo1 and the output voltage Vo2, i.e., voltage that is two times Vo1 and has the same phase, namely, the same polarity as Vo1, is applied.

The transformer 11 includes the primary-side winding m1 on the primary side and the secondary-side windings m2 on the secondary side. The transformer 11 has the secondary-side windings m2 interposed on the three-phase power lines 5u, 5v, 5w for the respective phases of the three-phase power lines 5. The injection voltage Vinj, which is difference voltage between the output voltage Vo1 outputted from the injection waveform generator 10a and the output voltage Vo2 outputted from the injection waveform generator 10b, is applied on the primary-side winding m1 of the transformer 11, and thus the compensation voltage Vcom which is voltage according to the turns ratio of the primary-side winding m1 and the secondary-side windings m2 and having a polarity opposite to the common mode voltage Vci, is generated on the secondary-side windings m2. The compensation voltage Vcom is superimposition voltage superimposed on the three-phase power lines 5.

The power converter 2 generates the common mode voltage Vci which changes in a step shape every time the semiconductor elements Q1 to Q6 perform switching operations. The common mode voltage Vci is detected by the noise detector 7 and then adjusted to the adjusted voltage Vd. The adjusted voltage Vd is subjected to band limitation and voltage value amplification by the injection waveform generators 10a, 10b, which thus output the output voltage Vo1 and the output voltage Vo2, and then the injection voltage Vinj which is a difference therebetween is inputted to the primary-side winding m1 of the transformer 11. The compensation voltage Vcom which is voltage generated on the secondary-side windings m2 of the transformer 11 has been set so as to reduce the common mode voltage Vci generated by the power converter 2.

Thus, in the noise filter 50 of Embodiment 1, on the basis of the common mode voltage Vci detected by the noise detector 7, the injection voltage Vinj which is adjusted voltage having a polarity opposite to the common mode voltage Vci is inputted to the transformer 11, so as to superimpose the compensation voltage Vcom on the three-phase power lines 5 for the respective phases, whereby the common mode voltage Vci can be reduced. The fact that the noise filter 50 of Embodiment 1 can have an enhanced noise reduction effect while having a reduced size and a reduced weight will be described below.

As the injection waveform generator 10a, first to third examples of injection waveform generators 10 shown in FIG. 4 to FIG. 6 can be adopted. As the injection waveform generator 10b, such an injection waveform generator 10 that the output voltage Vo2 has a phase opposite to the output voltage Vo1 of the injection waveform generator 10a, is adopted. In a case where any of the injection waveform generators 10 is adopted as the injection waveform generator 10a shown in FIG. 1, an input terminal 51, an output terminal 52, and output voltage Vo of the injection waveform generator 10 correspond to the input terminal 51a, the output terminal 52a, and the output voltage Vo1, respectively.

In a case where any of the injection waveform generators 10 is adopted as the injection waveform generator 10b shown in FIG. 1, the input terminal 51, the output terminal 52, and the output voltage Vo of the injection waveform generator 10 correspond to the input terminal 51b, the output terminal 52b, and the output voltage Vo2, respectively. The injection waveform generator 10a which outputs the output voltage Vo1 may be referred to as a first injection waveform generator 10a, and the injection waveform generator 10b which outputs the output voltage Vo2 may be referred to as a second injection waveform generator 10b.

The injection waveform generator 10 in the first example shown in FIG. 4 includes a band limiter 12, an amplifier 13, and control power supplies 15a, 15b. The control power supply 15a supplies positive-side voltage, and the control power supply 15b supplies negative-side voltage. Owing to the band limiter 12, only voltage in a reduction target frequency band, of the common mode voltage Vci, can be applied to the transformer 11, whereby the size of the transformer 11 can be reduced. The band limiter 12 is configured to allow passage in a target frequency band, and any of a band-pass filter, a low-pass filter, and a high-pass filter may be adopted.

The amplifier 13 shown in FIG. 4 is an example of an inverting amplifier circuit. The amplifier 13 includes an operational amplifier 19 and resistors 16, 17, 18. The ground potential is inputted to a positive-side input terminal of the operational amplifier 19 via the resistor 17. To a negative-side input terminal of the operational amplifier 19, an output of the band limiter 12 is inputted via the resistor 16 and an output of the operational amplifier 19 is inputted via the resistor 18.

A gain Gi of the operational amplifier 19 is represented by Expression (1), where the resistance values of the resistor 16 and the resistor 18 are denoted by r1 and r2, respectively. The output voltage Vo is represented by Expression (2).

$$Gi = r2/r1 \qquad ...\,(1)$$

$$Vo = -Gi \times Vd \qquad ...\,(2)$$

In the injection waveform generator 10 in the first example, a case where the amplifier 13 is an inverting amplifier circuit is shown, but the amplifier 13 may be a non-inverting amplifier circuit. The injection waveform generator 10 in the second example shown in FIG. 5 is an example of a non-inverting amplifier circuit. An output of the band limiter 12 is inputted to the positive-side input terminal of the operational amplifier 19 via the resistor 17. To the negative-side input terminal of the operational amplifier 19, the ground potential is inputted via the resistor 16 and an output of the operational amplifier 19 is inputted via the resistor 18.

A gain Gi of the operational amplifier 19 in the non-inverting amplifier circuit is represented by Expression (3), where the resistance values of the resistor 16 and the resistor 18 are denoted by r1 and r2, respectively. The output voltage Vo is represented by Expression (4).

$$Gi = 1+r2/r1 \qquad ...\,(3)$$

$$Vo = Gi \times Vd \qquad ...\,(4)$$

The injection waveform generators 10a, 10b output the output voltage Vo1 and the output voltage Vo2 having the same magnitude and opposite phases, and therefore, for example, the injection waveform generator 10a is configured as the non-inverting amplifier circuit and the injection waveform generator 10b is configured as the inverting amplifier circuit, thus satisfying the above requirements.

In a case where the first injection waveform generator 10a is configured as the non-inverting amplifier circuit and the second injection waveform generator 10b is configured as the inverting amplifier circuit, the output voltages Vo1, Vo2 are calculated by Expression (2) and Expression (4), respectively. The injection voltage Vinj is a difference between the output voltage Vo1 and the output voltage Vo2, and therefore is represented by Expression (5).

$$Vinj = Vo1-Vo2 \qquad ...\,(5)$$

Since the output voltages Vo1, Vo2 have the same magnitude and opposite phases, the injection voltage Vinj becomes a signal having an amplitude that is two times the output voltage Vo1 as shown by Expression (6).

$$Vinj = 2 \times Vo1 \qquad ...\,(6)$$

The gain Gi and a turns ratio Rr are set so that the compensation voltage Vcom which is voltage superimposed on each of the three-phase power lines 5 for u phase, v phase, and w phase via the secondary-side windings m2 of the transformer 11 reduces the common mode voltage Vci, i.e., Expression (7) is satisfied.

$$|Vci-Vcom| \le Vto \qquad ...\,(7)$$

Here, Vto is an allowable value for a voltage difference. Expression (7) indicates that the absolute value of a difference between the common mode voltage Vci and the compensation voltage Vcom is the allowable value Vto or less.

The turns ratio Rr of the transformer 11 is represented by Expression (8), where the numbers of turns of the primary-side winding m1 and the secondary-side winding m2 are denoted by N1 and N2, respectively.

$$Rr = N2/N1 \qquad ...\,(8)$$

The maximum voltage of the output voltage Vo of the injection waveform generator 10 is voltage of the control power supplies 15a, 15b. In a case where one injection waveform generator 10 is connected to the transformer 11 as in Patent Document 1, the maximum voltage of the injection voltage Vinj is voltage of the control power supplies 15a, 15b. However, in the noise filter 50 of Embodiment 1, the first injection waveform generator 10a and the second injection waveform generator 10b are provided, and the output voltages Vo1, Vo2 having the same magnitude and opposite phases are respectively inputted to one end and another end of the primary-side winding m1 of the transformer 11.

Thus, in the noise filter 50, the injection voltage Vinj whose maximum voltage is two times the voltage of the control power supplies 15a, 15b as shown by Expression (6) is obtained without increasing the output voltage Vo outputted by one injection waveform generator 10, i.e., without increasing the output voltage Vo1, Vo2 of each injection waveform generator 10a, 10b. As a result, the turns ratio Rr needed in the transformer 11 of Embodiment 1 in order to satisfy Expression (7) is decreased.

The transformer 11 includes one primary-side winding m1 and three secondary-side windings m2. A core of the transformer 11 is, for example, a toroidal core 28 shown in FIG. 9. Regarding the core 28, an inner diameter is l, an outer diameter is L, and a width (thickness) is h. If the turns ratio Rr is decreased and the number of turns of each secondary-side winding m2 is decreased, the inner diameter l of the core needed at minimum for configuring the transformer is also reduced, so that the size of the core and the size of the transformer can be reduced, whereby the size and the weight of the noise filter 50 can be reduced.

In a case where the first injection waveform generator 10a is configured as the inverting amplifier circuit and the second injection waveform generator 10b is configured as the non-inverting amplifier circuit, as shown in FIG. 7, connection to the primary-side winding m1 of the transformer 11 is changed to be reversed and setting is made so that the compensation voltage Vcom which is voltage outputted to the secondary-side windings m2 reduces the common mode voltage Vci. In the second noise filter 50 shown in FIG. 7, as in the first noise filter 50, the injection voltage Vinj shown by Expression (5) and Expression (6) can be applied on the primary-side winding m1 of the transformer 11.

In the noise filter 50 of Embodiment 1, the injection voltage Vinj whose maximum voltage is two times the voltage of the control power supplies 15a, 15b as shown by Expression (6) is obtained without increasing the output voltages Vo1, Vo2 that the injection waveform generators 10a, 10b output. Thus, as compared to a case where one injection waveform generator 10 is connected to the transformer 11 as in Patent Document 1, the voltage of control power supplies needed for obtaining the same injection voltage Vinj is halved. As a result, the sizes of the control power supplies 15a, 15b of the injection waveform generator 10 can be reduced, whereby the size and the weight of the noise filter 50 can be reduced.

The injection waveform generator 10 in the third example shown in FIG. 6 will be described. The injection waveform generator 10 in the third example is different from the injection waveform generator 10 in the first example in that a current buffer 14 is added between an output terminal of the amplifier 13 and an output terminal 52. The output terminal of the amplifier 13 is a connection point between the resistor 18 and a line through which an output of the operational amplifier 19 is sent. In the injection waveform generator 10 in the third example, a current capacity which indicates a current supply amount can be increased as compared to the injection waveform generator 10 in the first example. The current buffer 14 includes two transistors BT1, BT2 connected in series, for example.

A collector c of the transistor BT1 is connected to the control power supply 15a, an emitter e of the transistor BT1 is connected to an emitter e of the transistor BT2, and a collector c of the transistor BT2 is connected to the control power supply 15b. An output of the amplifier 13 is inputted to bases b of the transistors BT1, BT2, and the emitters e of the transistors BT1, BT2 are connected to the output terminal 52. The current buffer 14 may be added to the injection waveform generator 10 in the second example.

In FIG. 1, a case where the noise detector 7 is connected to the three-phase power lines 5 has been shown. However, as shown in FIG. 8, the noise detector 7 may be connected to the three-phase power lines 4. Also in this case, the common mode voltage Vci detected from the three-phase power lines 4 is equivalent to the common mode voltage Vci detected from the three-phase power lines 5, and therefore Expression (7) is to be satisfied.

In FIG. 1, a case where the transformer 11 is interposed on the three-phase power lines 5 has been shown. However, as shown in FIG. 7, the positions of the transformer 11 and the noise detector 7 may be reversed. The noise filter 50 in the first example shown in FIG. 1 has a feedforward configuration, whereas the noise filter 50 in the second example shown in FIG. 7 has a feedback configuration.

As an example of the signal adjustment circuit 9, a case of including the capacitor 91, the differential amplifier 92, and the band limiter 93 has been shown. However, the signal adjustment circuit 9 is not limited thereto. The signal adjustment circuit 9 may have a configuration including only the capacitor 91 and the differential amplifier 92, a configuration in which the capacitor 91 is replaced with a resistor, or a configuration in which the number of capacitors and resistors is increased. In a case of not dividing the common mode voltage Vci, the signal adjustment circuit 9 may include only the band limiter 93.

As in a fourth noise filter 50 of Embodiment 1 shown in FIG. 10, for example, the adjusted voltage Vd outputted from the noise detector 7 may be inputted to only the first injection waveform generator 10a, the output terminal 52a of the first injection waveform generator 10a may be connected to one end of the primary-side winding m1 of the transformer 11 and the input terminal 51b of the second injection waveform generator 10b, and the output terminal 52b of the second injection waveform generator 10b may be connected to another end of the primary-side winding m1 of the transformer 11. The second injection waveform generator 10b receives the output voltage Vo1 outputted from the first injection waveform generator 10a. A fourth injection voltage generator 30 in Embodiment 1 includes the first injection waveform generator 10a which generates the first output voltage Vo1 on the basis of the adjusted voltage Vd, and the second injection waveform generator 10b which generates the second output voltage Vo2 on the basis of the first output voltage Vo1.

Also in this case, the output voltage Vo1 of the first injection waveform generator 10a and the output voltage Vo2 of the second injection waveform generator 10b are voltages having the same magnitude and opposite phases. In order to output the output voltage Vo2 having the same magnitude as and a phase opposite to the output voltage Vo1, the second injection waveform generator 10b has such a circuit that turns the phase of the input signal by 180° with a gain of factor 1. That is, the gain Gi of the operational amplifier 19 of the second injection waveform generator 10b is -1 in a case where the gain Gi of the first injection waveform generator 10a is positive, and 1 in a case where the gain Gi of the first injection waveform generator 10a is negative.

In the fourth noise filter 50 of Embodiment 1, the second injection waveform generator 10b has only to turn the phase of the input signal by 180° with a gain of factor 1, and therefore it suffices that the band limiter 12 is provided in the first injection waveform generator 10a.

Thus, the band limiter 12 of the second injection waveform generator 10b can be removed.

As in a fifth noise filter 50 of Embodiment 1 shown in FIG. 11, for example, the signal adjustment circuit 9 included in the noise detector 7 may have two output terminals 95a, 95b, from which adjusted voltages Vd1, Vd2 having the same magnitude and opposite phases are outputted. Then, the adjusted voltage Vd1 may be inputted to the first injection waveform generator 10a, and the adjusted voltage Vd2 may be inputted to the second injection waveform generator 10b. Also in this case, the output voltage Vo1 of the first injection waveform generator 10a and the output voltage Vo2 of the second injection waveform generator 10b are voltages having the same magnitude and opposite phases. The output terminal 95a may be referred to as a first output terminal 95a, and the output terminal 95b may be referred to as a second output terminal 95b. The adjusted voltage Vd1 may be referred to as first adjusted voltage Vd1, and the adjusted voltage Vd2 may be referred to as second adjusted voltage Vd2.

In the fifth noise filter 50 of Embodiment 1, for example, the signal adjustment circuit 9 shown in FIG. 12 may be applied. The signal adjustment circuit 9 shown in FIG. 12 is different from the signal adjustment circuit 9 in FIG. 3 in that two differential amplifiers 92a, 92b, two band limiters 93a, 93b, and two output terminals 95a, 95b are provided. The differential amplifier 92b is connected in parallel with the differential amplifier 92a, and a non-inverting input terminal of the differential amplifier 92a and an inverting input terminal of the differential amplifier 92b are connected to each other, and an inverting input terminal of the differential amplifier 92a and a non-inverting input terminal of the differential amplifier 92b are connected to each other. Outputs of the differential amplifiers 92a, 92b are connected to the band limiters 93a, 93b having the same configuration, and the adjusted voltages Vd1, Vd2 are outputted from the output terminals 95a, 95b.

Since the adjusted voltages Vd1, Vd2 have the same magnitude and opposite phases, the injection waveform generators 10a, 10b can be configured by circuits having the same gain and the same phase characteristic. That is, the same common circuits can be used, and thus error between the characteristics of the injection waveform generators 10a, 10b can be reduced.

In the fifth noise filter 50 of Embodiment 1, the adjusted voltages Vd1, Vd2 outputted from the output terminals 95a, 95b may have different magnitudes and the same phase. In accordance with the adjusted voltages Vd1, Vd2, setting is made such that the injection waveform generators 10a, 10b to which the adjusted voltages Vd1, Vd2 are inputted respectively output the output voltages Vo1, Vo2 having the same magnitude and opposite phases.

Thus, in the fifth noise filter 50 of Embodiment 1, as in the first noise filter 50 of Embodiment 1, the injection voltage Vinj whose maximum voltage is two times the voltage of the control power supplies 15a, 15b is obtained without increasing the output voltage Vo outputted by one injection waveform generator 10, i.e., without increasing the output voltage Vo1, Vo2 of each injection waveform generator 10a, 10b. As a result, in the fifth noise filter 50 of Embodiment 1, the size of the transformer 11 or the control power supplies 15a, 15b can be reduced, whereby the size and the weight of the noise filter 50 can be reduced.

In the fifth noise filter 50 of Embodiment 1, the noise detector 7 includes the capacitors 8 and the signal adjustment circuit 9 connected in series between the line 24 which is the ground line and the three-phase power lines 5, 4 on the output side or the input side of the power converter 2. In the fifth noise filter 50 of Embodiment 1, the signal adjustment circuit 9 outputs the first adjusted voltage Vd1 and the second adjusted voltage Vd2 which are two adjusted voltages on the basis of the common mode voltage Vci which is input voltage inputted via the capacitors 8, and the injection voltage generator 30 includes the first injection waveform generator 10a which generates the first output voltage Vo1 on the basis of the first adjusted voltage Vd1, and the second injection waveform generator 10b which generates the second output voltage Vo2 on the basis of the second adjusted voltage Vd2. Thus, in the fifth noise filter 50 of Embodiment 1, the size of the transformer 11 or the control power supplies 15a, 15b can be reduced, whereby the size and the weight of the noise filter 50 can be reduced.

In Embodiment 1, a case where the output voltage Vo1 and the output voltage Vo2 have the same magnitude has been shown. However, the output voltage Vo1 and the output voltage Vo2 may have different magnitudes. Also in a case where their magnitudes are different, a difference between the output voltage Vo1 and the output voltage Vo2, i.e., the injection voltage Vinj which is voltage greater than the output voltage Vo1 and having the same phase as the output voltage Vo1, is applied on the primary-side winding m1 of the transformer 11. As a result, in the noise filter 50 of Embodiment 1, the size of the transformer 11 or the control power supplies 15a, 15b can be reduced, whereby the size and the weight of the noise filter 50 can be reduced.

As described above, the noise filter 50 of Embodiment 1 is a noise filter that reduces voltage or current (common mode voltage Vci) of electromagnetic noise generated by the power converter 2 performing power conversion through switching operations of the semiconductor elements Q1 to Q6. The noise filter 50 includes: the noise detector 7 which detects voltage (common mode voltage Vci) based on electromagnetic noise generated by the power converter 2 and outputs the adjusted voltage Vd obtained by adjusting the voltage (common mode voltage Vci) based on the electromagnetic noise; the compensation signal applicator 75 which superimposes the compensation voltage Vcom having a polarity opposite to the voltage (common mode voltage Vci) based on the electromagnetic noise, on an output or an input of the power converter 2 via the transformer 11; and the injection voltage generator 30 which generates, on the basis of the adjusted voltage Vd, the first output voltage Vo1 and the second output voltage Vo2 having a polarity opposite to the first output voltage Vo1, for generating the injection voltage Vinj between one end and another end of the primary-side winding m1 of the transformer 11, and which outputs the first output voltage Vo1 to the one end of the primary-side winding m1 of the transformer 11 and outputs the second output voltage Vo2 to the other end of the primary-side winding m1 of the transformer 11.

The injection voltage generator 30 generates the first output voltage Vo1 and the second output voltage Vo2 for generating the injection voltage Vinj so that a difference between the compensation voltage Vcom superimposed by the compensation signal applicator 75 and the voltage (common mode voltage Vci) based on the electromagnetic noise becomes the allowable value Vto or less. With this configuration, in the noise filter 50 of Embodiment 1, the first output voltage Vo1 and the second output voltage Vo2 having a polarity opposite to the first output voltage Vo1 are respectively applied to both ends of the primary-side winding m1 of the transformer 11 of the compensation signal applicator 75, and the compensation voltage Vcom is superimposed on the output or the input of the power converter 2 on the basis of the injection voltage Vinj having the same polarity as the first output voltage Vo1 and greater than the first output voltage Vo1. Thus, the noise filter 50 can have an enhanced noise reduction effect while having a reduced size and a reduced weight.

In the noise filter 50 of Embodiment 1, the injection voltage generator 30 includes two injection waveform generators 10a, 10b, and the output voltages Vo1, Vo2 having opposite phases (opposite polarities) are applied on the primary-side winding m1 of the transformer 11 of the compensation signal applicator 75, whereby large injection voltage Vinj is obtained without increasing the output of one injection waveform generator, i.e., without increasing the voltage of the control power supplies 15a, 15b. Since amplification based on the turns ratio Rr of the transformer 11 can be reduced, the number of turns of the transformer 11 can be decreased, whereby the size of the transformer 11 can be reduced. Also in a case of reducing the output voltage per injection waveform generator without changing the turns ratio Rr of the transformer 11, the voltage of the control power supplies 15a, 15b can be reduced, whereby the size of the control power supplies 15a, 15b can be reduced. Thus, the noise filter 50 of Embodiment 1 makes it possible to reduce the size of the entire noise filter.

Embodiment 2

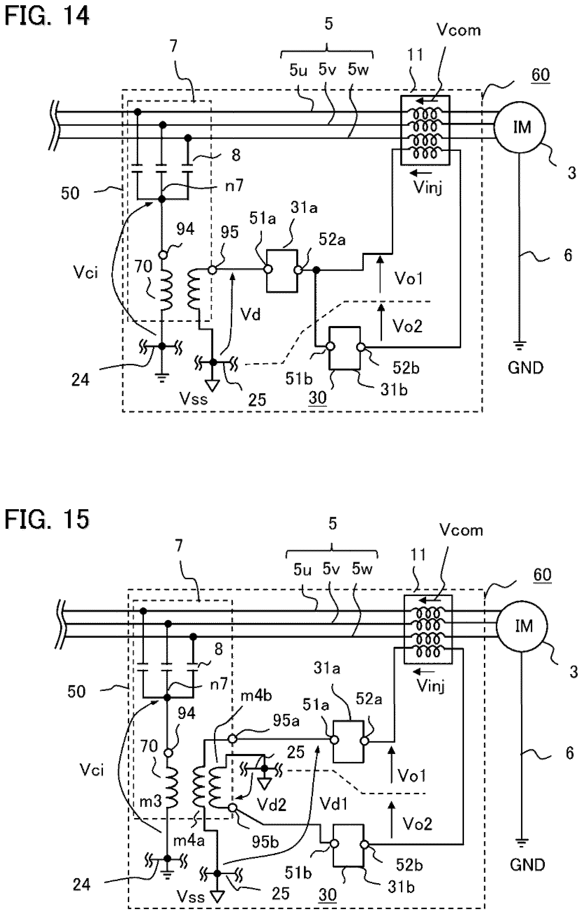

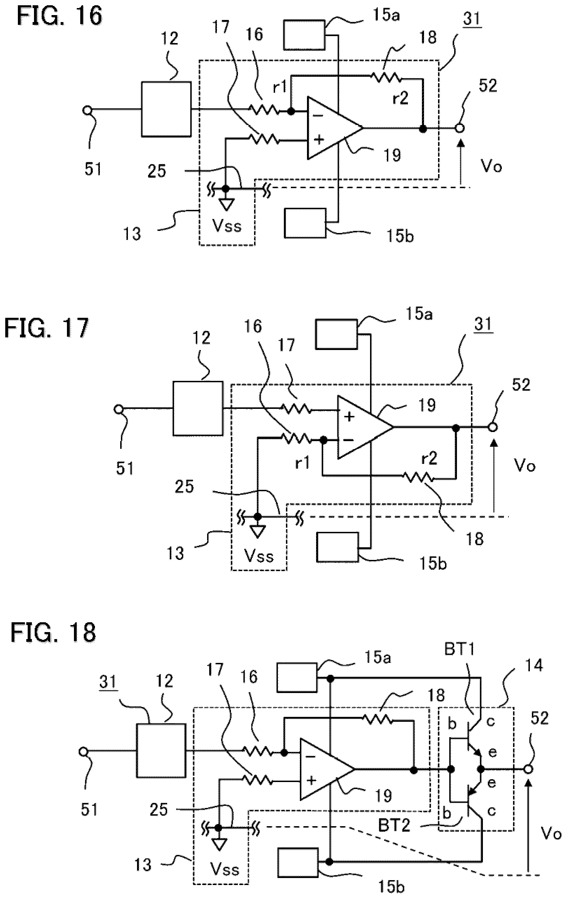

FIG. 13 shows the configuration of a first noise filter and an electric motor driving system according to Embodiment 2, and FIG. 14 shows the configuration of a second noise filter and an electric motor driving system according to Embodiment 2. FIG. 15 shows the configuration of a third noise filter and an electric motor driving system according to Embodiment 2. FIG. 16 shows a first example of an injection waveform generator in Embodiment 2, FIG. 17 shows a second example of an injection waveform generator in Embodiment 2, and FIG. 18 shows a third example of an injection waveform generator in Embodiment 2. As in Embodiment 1, the noise filter 50 of Embodiment 2 is applicable to the electric motor driving system 60 which is a system for controlling the induction electric motor 3 by the power converter 2 such as a voltage-type PWM inverter in which a plurality of semiconductor elements perform switching operations.

The noise filter 50 of Embodiment 2 is different from the noise filter 50 of Embodiment 1 in that the noise detector 7 includes a voltage division transformer 70 instead of the signal adjustment circuit 9, and the injection waveform generators 10a, 10b using the potential of the ground GND, i.e., the ground potential, as a reference, are replaced with injection waveform generators 31a, 31b using a reference potential Vss which is a potential separate from the ground GND, as a reference. Differences from the noise filter 50 of Embodiment 1 will be mainly described. The voltage division transformer 70 includes a primary-side winding m3 on the primary side and a secondary-side winding m4 on the secondary side as in the transformer 11, the input terminal 94 is connected to one end of the primary-side winding m3, and the output terminal 95 is connected to one end of the secondary-side winding m4.

The noise detector 7 includes the three capacitors 8 having equal capacitances, and the voltage division transformer 70, and ends of the capacitors 8 are connected to the three-phase power lines 5 for the respective phases. Other ends of the capacitors 8 are connected to each other at the connection point n7. Regarding the voltage division transformer 70, the input terminal 94 to which the one end of the primary-side winding m3 is connected is connected to the connection point n7, and another end of the primary-side winding m3 is connected to the line 24 having the ground potential. In addition, regarding the voltage division transformer 70, the one end of the secondary-side winding m4 is connected to the output terminal 95, and another end of the secondary-side winding m4 is connected to a line 25 having the reference potential Vss for the injection voltage generator 30 and the like. The line 25 is a reference line having the reference potential Vss.

The noise detector 7 in Embodiment 2 includes the capacitors 8 and the voltage division transformer 70 connected in series between the line 24 which is a ground line and the three-phase power lines 5, 4 on the output side or the input side of the power converter 2. The primary-side winding m3 of the voltage division transformer 70 has one end connected to ends of the capacitors 8 on the side opposite to the three-phase power lines 5, 4, and another end connected to the line 24 which is the ground line.

The secondary-side winding m4 of the voltage division transformer 70 has one end connected to the line 25 which is the reference line having the reference potential Vss different from the ground potential of the line 24 which is the ground line, and another end connected to the output terminal 95 for outputting the adjusted voltage Vd. In the noise detector 7, the voltage division transformer 70 outputs the adjusted voltage Vd on the basis of the common mode voltage Vci which is the input voltage inputted via the capacitors 8. In FIG. 13, a case where the noise detector 7 is connected to the three-phase power lines 5 is shown.

Regarding the voltage division transformer 70, the end of the primary-side winding m3 on the side opposite to the input terminal 94 is connected to the line 24 having the ground potential, and the end of the secondary-side winding m4 on the side opposite to the output terminal 95 is connected to the line 25 having the reference potential Vss. Thus, the noise detector 7 which detects noise of the power converter 2 operating with large power, and the injection waveform generators 31a, 31b driven by the control power supplies 15a, 15b, can be isolated from each other.

The voltage divided by a combined impedance of the capacitors 8 and an impedance of the voltage division transformer 70 connected in series thereto, i.e., the divided common mode voltage Vci, is applied on the primary-side winding m3 of the voltage division transformer 70, and the adjusted voltage Vd according to the turns ratio of the primary-side winding m3 and the secondary-side winding m4 of the voltage division transformer 70 is inputted to the injection waveform generators 31a, 31b. In the noise detector 7 of Embodiment 2, the common mode voltage Vci which is the input voltage between the line 24 having the ground potential and the input terminal 94 is voltage divided by the impedance of the voltage division transformer 70.

As described in Embodiment 1, the output voltage Vo1 outputted from the injection waveform generator 31a and the output voltage Vo2 outputted from the injection waveform generator 31b are voltages having the same magnitude and opposite phases, and are respectively applied to one end and another end of the primary-side winding m1 of the transformer 11, whereby the injection voltage Vinj corresponding to the difference is applied. In the transformer 11, the compensation voltage Vcom is generated between both ends of each secondary-side winding m2 in accordance with the turns ratio Rr, whereby the compensation voltage Vcom is applied on the three-phase power lines 5 for the respective phases. In the noise filter 50 of Embodiment 2, as in the noise filter 50 of Embodiment 1, the injection voltage Vinj whose maximum voltage is two times the voltage of the control power supplies 15a, 15b is obtained without increasing the output voltage Vo outputted by one injection waveform generator 31, i.e., without increasing the output voltage Vo1, Vo2 of each injection waveform generator 31a, 31b.

As a result, in the noise filter 50 of Embodiment 2, the size of the transformer 11 or the control power supplies 15a, 15b can be reduced, whereby the size and the weight of the noise filter 50 can be reduced. Thus, the noise filter 50 of Embodiment 2 can reduce the common mode voltage Vci while having a reduced size and a reduced weight, i.e., can have an enhanced noise reduction effect while having a reduced size and a reduced weight. The injection waveform generator 31a which outputs the output voltage Vo1 may be referred to as a first injection waveform generator 31a, and the injection waveform generator 31b which outputs the output voltage Vo2 may be referred to as a second injection waveform generator 31b.

As the injection waveform generator 31a, first to third examples of injection waveform generators 31 shown in FIG. 16 to FIG. 18 can be adopted. As the injection waveform generator 31b, such an injection waveform generator 31 that the output voltage Vo2 has a phase opposite to the output voltage Vo1 of the injection waveform generator 31a is adopted. The first example of the injection waveform generator 31 shown in FIG. 16 is different in the reference potential, as compared to the first example of the injection waveform generator 10 shown in FIG. 4. Specifically, the difference is that the line 24 having the ground potential in FIG. 4 is replaced with the line 25 having the reference potential Vss in FIG. 16.

The second example of the injection waveform generator 31 shown in FIG. 17 is different in the reference potential, as compared to the second example of the injection waveform generator 10 shown in FIG. 5. The third example of the injection waveform generator 31 shown in FIG. 18 is different in the reference potential, as compared to the third example of the injection waveform generator 10 shown in FIG. 6. Specifically, the differences are that the line 24 having the ground potential in FIG. 5 and FIG. 6 is replaced with the line 25 having the reference potential Vss in FIG. 17 and FIG. 18. The current buffer 14 may be added to the injection waveform generator 31 in the second example.

In a case where any of the injection waveform generators 31 is adopted as the injection waveform generator 31a shown in FIG. 13, the input terminal 51, the output terminal 52, and the output voltage Vo of the injection waveform generator 31 correspond to the input terminal 51a, the output terminal 52a, and the output voltage Vo1, respectively. In a case where any of the injection waveform generators 31 is adopted as the injection waveform generator 31b shown in FIG. 13, the input terminal 51, the output terminal 52, and the output voltage Vo of the injection waveform generator 31 correspond to the input terminal 51b, the output terminal 52b, and the output voltage Vo2, respectively.

As in the second noise filter 50 of Embodiment 2 shown in FIG. 14, for example, the adjusted voltage Vd outputted from the noise detector 7 may be inputted to only the first injection waveform generator 31a, the output terminal 52a of the first injection waveform generator 31a may be connected to one end of the primary-side winding m 1 of the transformer 11 and the input terminal 51b of the second injection waveform generator 31b, and the output terminal 52b of the second injection waveform generator 31b may be connected to another end of the primary-side winding m1 of the transformer 11. Also in this case, the output voltage Vo1 of the first injection waveform generator 31a and the output voltage Vo2 of the second injection waveform generator 31b are voltages having the same magnitude and opposite phases.

In the second noise filter 50 of Embodiment 2, as in the fourth noise filter 50 of Embodiment 1, the second injection waveform generator 31b receives Vo1 outputted from the first injection waveform generator 31a. In order to output the output voltage Vo2 having the same magnitude as and a phase opposite to the output voltage Vo1, the second injection waveform generator 31b has such a circuit that turns the phase of the input signal by 180° with a gain of factor 1. That is, the gain Gi of the operational amplifier 19 of the second injection waveform generator 3 1b is -1 in a case where the gain Gi of the first injection waveform generator 31a is positive, and 1 in a case where the gain Gi of the first injection waveform generator 31a is negative.

In the second noise filter 50 of Embodiment 2, the second injection waveform generator 3 1b has only to turn the phase of the input signal by 180° with a gain of factor 1, and therefore it suffices that the band limiter 12 is provided in the first injection waveform generator 31a. Thus, the band limiter 12 of the second injection waveform generator 31b can be removed.

As in the third noise filter 50 of Embodiment 2 shown in FIG. 15, for example, the voltage division transformer 70 included in the noise detector 7 may have two secondary-side windings m4a, m4b, and adjusted voltages Vd1, Vd2 having the same magnitude and opposite phases may be outputted from the output terminals 95a, 95b connected to the respective secondary-side windings m4a, m4b. Then, the adjusted voltage Vd1 may be inputted to the first injection waveform generator 31a, and the adjusted voltage Vd2 may be inputted to the second injection waveform generator 31b. The voltage division transformer 70 shown in FIG. 15 will be described in detail.

The voltage division transformer 70 has the first secondary-side winding m4a and the second secondary-side winding m4b, the first secondary-side winding m4a is configured with the same polarity as the primary-side winding m3, and the second secondary-side winding m4b is configured with a polarity opposite to the primary-side winding m3. The first secondary-side winding m4a has one end connected to the output terminal 95a, and another end connected to the line 25 having the reference potential Vss. The second secondary-side winding m4b has one end connected to the output terminal 95b, and another end connected to the line 25 having the reference potential Vss. The output terminal 95a of the voltage division transformer 70 is connected to the input terminal 51a of the first injection waveform generator 31a, and the output terminal 95b of the voltage division transformer 70 is connected to the input terminal 51b of the second injection waveform generator 31b.

Since the adjusted voltages Vd1, Vd2 have the same magnitude and opposite phases, the injection waveform generators 31a, 31b can be configured by circuits having the same gain and the same phase characteristic. That is, the same common circuits can be used, and thus error between the characteristics of the injection waveform generators 31a, 31b can be reduced.

In the third noise filter 50 of Embodiment 2, the polarities of the first secondary-side winding m4a and the second secondary-side winding m4b of the voltage division transformer 70 may be the same as or different from that of the primary-side winding m3, and the numbers of winding turns may be different. That is, the adjusted voltages Vd1, Vd2 outputted from the output terminals 95a, 95b of the voltage division transformer 70 may have different magnitudes and the same phase. In accordance with the adjusted voltages Vd1, Vd2, setting is made such that the injection waveform generators 31a, 31b to which the adjusted voltages Vd1, Vd2 are inputted respectively output the output voltages Vo1, Vo2 having the same magnitude and opposite phases.

Thus, in the third noise filter 50 of Embodiment 2, as in the first noise filter 50 of Embodiment 2, the injection voltage Vinj whose maximum voltage is two times the voltage of the control power supplies 15a, 15b is obtained without increasing the output voltage Vo outputted by one injection waveform generator 31, i.e., without increasing the output voltage Vo1, Vo2 of each injection waveform generator 31a, 31b. As a result, in the third noise filter 50 of Embodiment 2, the size of the transformer 11 or the control power supplies 15a, 15b can be reduced, whereby the size and the weight of the noise filter 50 can be reduced.

In the third noise filter 50 of Embodiment 2, the noise detector 7 includes the capacitors 8 and the voltage division transformer 70 connected in series between the line 24 which is the ground line and the three-phase power lines 5, 4 on the output side or the input side of the power converter 2. In the third noise filter 50 of Embodiment 2, the voltage division transformer 70 has the two secondary-side windings m4a, m4b, one end of the primary-side winding m3 is connected to the connection point n7 at ends of the capacitors 8 on the side opposite to the three-phase power lines 5, 4, and another end of the primary-side winding m3 is connected to the line 24 which is the ground line.

Regarding the voltage division transformer 70, the first secondary-side winding m4a which is one of the secondary-side windings has one end connected to the line 25 which is the reference line having the reference potential Vss different from the ground potential of the ground line, and another end connected to the first output terminal 95a for outputting the first adjusted voltage Vd1 which is the adjusted voltage for first. The second secondary-side winding m4b which is the other secondary-side winding has one end connected to a reference line, and another end connected to the second output terminal 95b for outputting the second adjusted voltage Vd2 which is the adjusted voltage for second.

In the third noise filter 50 of Embodiment 2, the injection voltage generator 30 includes the first injection waveform generator 31a which generates the first output voltage Vo1 on the basis of the first adjusted voltage Vd1, and the second injection waveform generator 3 1b which generates the second output voltage Vo2 on the basis of the second adjusted voltage Vd2. Thus, in the third noise filter 50 of Embodiment 2, the size of the transformer 11 or the control power supplies 15a, 15b can be reduced, whereby the size and the weight of the noise filter 50 can be reduced.

In Embodiment 2, a case where the output voltage Vo1 and the output voltage Vo2 have the same magnitude has been shown. However, as in Embodiment 1, the output voltage Vo1 and the output voltage Vo2 may have different magnitudes. Also in a case where their magnitudes are different, a difference between the output voltage Vo1 and the output voltage Vo2, i.e., the injection voltage Vinj which is voltage greater than the output voltage Vo1 and having the same phase as the output voltage Vo1, is applied on the primary-side winding m1 of the transformer 11. As a result, in the noise filter 50 of Embodiment 2, the size of the transformer 11 or the control power supplies 15a, 15b can be reduced, whereby the size and the weight of the noise filter 50 can be reduced. Although the noise filter 50 of Embodiment 2 shown in FIG. 13 to FIG. 15 has a feedforward configuration, the positions of the transformer 11 and the noise detector 7 may be changed to each other so as to make a feedback configuration.

Embodiment 3

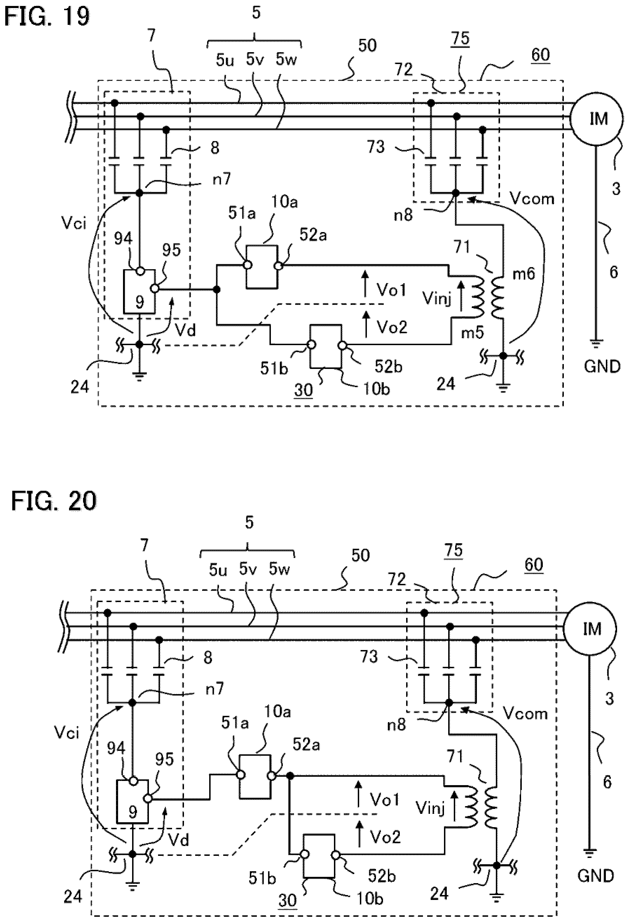

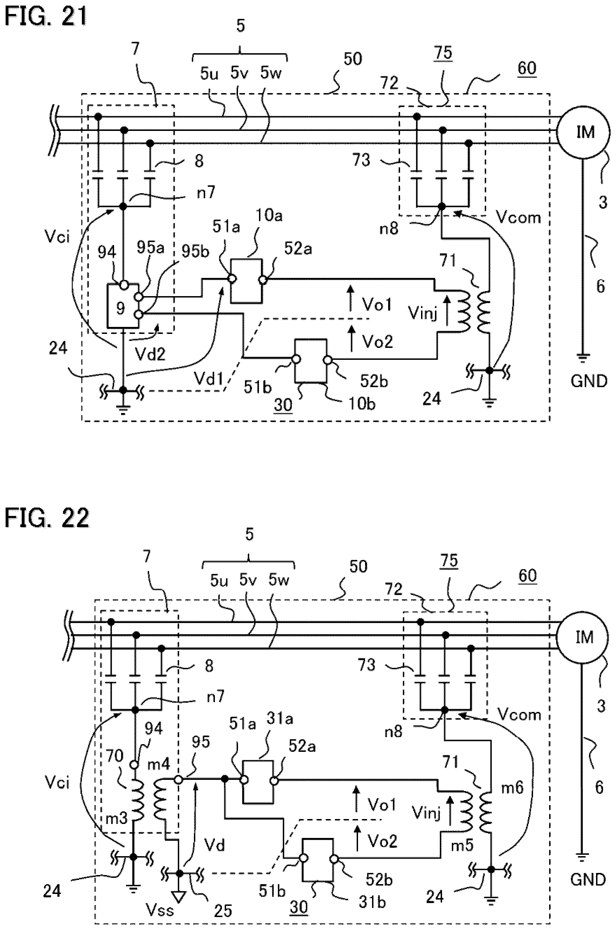

FIG. 19 shows the configuration of a first noise filter and an electric motor driving system according to Embodiment 3, and FIG. 20 shows the configuration of a second noise filter and an electric motor driving system according to Embodiment 3. FIG. 21 shows the configuration of a third noise filter and an electric motor driving system according to Embodiment 3. As in Embodiment 1, the noise filter 50 of Embodiment 3 is applicable to the electric motor driving system 60 which is a system for controlling the induction electric motor 3 by the power converter 2 such as a voltage-type PWM inverter in which a plurality of semiconductor elements perform switching operations.

The noise filter 50 of Embodiment 3 is different from the noise filter 50 of Embodiment 1 in that the compensation signal applicator 75 includes a signal adjustment transformer 71 and a signal applicator 72 instead of the transformer 11. The compensation signal applicator 75 in Embodiment 3 includes the signal adjustment transformer 71 which is a transformer having a primary-side winding m5 on the primary side and a secondary-side winding m6 on the secondary side, and the signal applicator 72 including capacitors 73. The secondary-side winding m6 of the signal adjustment transformer 71 has one end connected to the line 24 which is the ground line, and another end connected to the three-phase power lines 5, 4 on the output side or the input side of the power converter 2 via the capacitors 73 of the signal applicator 72. In FIG. 19, a case where the compensation signal applicator 75 is connected to the three-phase power lines 5 is shown.

For example, regarding the signal applicator 72, ends of the three capacitors 73 having equal capacitances are connected to the three-phase power lines 5 for the respective phases, and other ends of the three capacitors 73 are connected to each other at a connection point n8. Regarding the signal adjustment transformer 71, the output terminals 52a, 52b of the injection waveform generator 10a and the injection waveform generator 10b are respectively connected to both ends of the primary-side winding m5, one end of the secondary-side winding m6 is connected to the line 24 which is the ground potential, and another end thereof is connected to the connection point n8. Differences from the noise filter 50 of Embodiment 1 will be mainly described.

The output voltage Vo1 outputted from the output terminal 52a of the injection waveform generator 10a is inputted to one end of the primary-side winding m5 of the signal adjustment transformer 71. The output voltage Vo2 outputted from the output terminal 52b of the injection waveform generator 10b is inputted to another end of the primary-side winding m5 of the signal adjustment transformer 71. The output voltage Vo1 and the output voltage Vo2 are voltages having the same magnitude and opposite phases. That is, the output voltage Vo1 and the output voltage Vo2 are voltages having the same magnitude and opposite polarities.

On the primary-side winding m5 of the signal adjustment transformer 71, a difference between the output voltage Vo1 and the output voltage Vo2, i.e., the injection voltage Vinj which is voltage that is two times Vo1 and has the same phase, namely, the same polarity as Vo1, is applied. The compensation voltage Vcom is superimposed on the three-phase power lines 5 for the respective phases via the capacitors 73 of the signal applicator 72 so as to reduce the common mode voltage Vci. Then, current for reducing the common mode voltage Vci flows through the three-phase power line 5 for each phase via the capacitor 73 of the signal applicator 72.

In the first noise filter 50 of Embodiment 3, since the injection waveform generator 10a and the injection waveform generator 10b output the output voltages Vo1, Vo2 having the same magnitude and opposite phases, a difference between the output voltage Vo1 and the output voltage Vo2, i.e., the injection voltage Vinj that is two times Vo1 and has the same phase as Vo1, is applied on the primary-side winding m5 of the signal adjustment transformer 71. That is, in the first noise filter 50 of Embodiment 3, the injection voltage Vinj whose maximum voltage is two times the voltage of the control power supplies 15a, 15b as shown by Expression (6) is obtained without increasing the output voltage Vo outputted by one injection waveform generator 10, i.e., without increasing the output voltage Vo1, Vo2 of each injection waveform generator 10a, 10b. As a result, the size of the signal adjustment transformer 71 or the control power supplies 15a, 15b can be reduced. Thus, the first noise filter 50 of Embodiment 3 can reduce the common mode voltage Vci while having a reduced size and a reduced weight, i.e., can have an enhanced noise reduction effect while having a reduced size and a reduced weight.

As in the second noise filter 50 of Embodiment 3 shown in FIG. 20, for example, the adjusted voltage Vd outputted from the noise detector 7 may be inputted to only the first injection waveform generator 10a, the output terminal 52a of the first injection waveform generator 10a may be connected to one end of the primary-side winding m5 of the signal adjustment transformer 71 and the input terminal 51b of the second injection waveform generator 10b, and the output terminal 52b of the second injection waveform generator 10b may be connected to another end of the primary-side winding m5 of the signal adjustment transformer 71. Also in this case, the output voltage Vo1 of the first injection waveform generator 10a and the output voltage Vo2 of the second injection waveform generator 10b are voltages having the same magnitude and opposite phases.

In the second noise filter 50 of Embodiment 3, as in the fourth noise filter 50 of Embodiment 1, the second injection waveform generator 10b receives Vo1 outputted from the first injection waveform generator 10a. In order to output the output voltage Vo2 having the same magnitude as and a phase opposite to the output voltage Vo1, the second injection waveform generator 10b has such a circuit that turns the phase of the input signal by 180° with a gain of factor 1. That is, the gain Gi of the operational amplifier 19 of the second injection waveform generator 10b is -1 in a case where the gain Gi of the first injection waveform generator 10a is positive, and 1 in a case where the gain Gi of the first injection waveform generator 10a is negative.

In the second noise filter 50 of Embodiment 3, the second injection waveform generator 10b has only to turn the phase of the input signal by 180° with a gain of factor 1, and therefore, as long as the band limiter 12 is provided in the first injection waveform generator 10a, the band limiter 12 of the second injection waveform generator 10b can be removed.

As in the third noise filter 50 of Embodiment 3 shown in FIG. 21, for example, the signal adjustment circuit 9 included in the noise detector 7 may have two output terminals 95a, 95b, from which adjusted voltages Vd1, Vd2 having the same magnitude and opposite phases are outputted. Then, the adjusted voltage Vd1 may be inputted to the first injection waveform generator 10a, and the adjusted voltage Vd2 may be inputted to the second injection waveform generator 10b. Also in this case, the output voltage Vo1 of the first injection waveform generator 10a and the output voltage Vo2 of the second injection waveform generator 10b are voltages having the same magnitude and opposite phases.

Since the adjusted voltages Vd1, Vd2 have the same magnitude and opposite phases, the injection waveform generators 10a, 10b can be configured by circuits having the same gain and the same phase characteristic. That is, the same common circuits can be used, and thus error between the characteristics of the injection waveform generators 10a, 10b can be reduced.

In the third noise filter 50 of Embodiment 3, as in the fifth noise filter 50 of Embodiment 1, the adjusted voltages Vd1, Vd2 outputted from the output terminals 95a, 95b may have different magnitudes and the same phase. In accordance with the adjusted voltages Vd1, Vd2, setting is made such that the injection waveform generators 10a, 10b to which the adjusted voltages Vd1, Vd2 are inputted respectively output the output voltages Vo1, Vo2 having the same magnitude and opposite phases. Thus, in the third noise filter 50 of Embodiment 3, the injection voltage Vinj whose maximum voltage is two times the voltage of the control power supplies 15a, 15b is obtained without increasing the output voltage Vo outputted by one injection waveform generator 10, i.e., without increasing the output voltage Vo1, Vo2 of each injection waveform generator 10a, 10b. As a result, in the third noise filter 50 of Embodiment 3, the size of the signal adjustment transformer 71 or the control power supplies 15a, 15b can be reduced, whereby the size and the weight of the noise filter 50 can be reduced.

In Embodiment 3, a case where the output voltage Vo1 and the output voltage Vo2 have the same magnitude has been shown. However, as in Embodiment 1, the output voltage Vo1 and the output voltage Vo2 may have different magnitudes. Also in a case where their magnitudes are different, a difference between the output voltage Vo1 and the output voltage Vo2, i.e., the injection voltage Vinj which is greater than Vo1 and has the same phase as Vo1, is applied on the primary-side winding m5 of the signal adjustment transformer 71. As a result, in the noise filter 50 of Embodiment 3, the size of the signal adjustment transformer 71 or the control power supplies 15a, 15b can be reduced, whereby the size and the weight of the noise filter 50 can be reduced.

Although the noise filter 50 of Embodiment 3 shown in FIG. 19 to FIG. 21 has a feedforward configuration, the position of the signal applicator 72 and the signal adjustment transformer 71, i.e., the compensation signal applicator 75, and the position of the noise detector 7, may be changed to each other so as to make a feedback configuration.

Embodiment 4

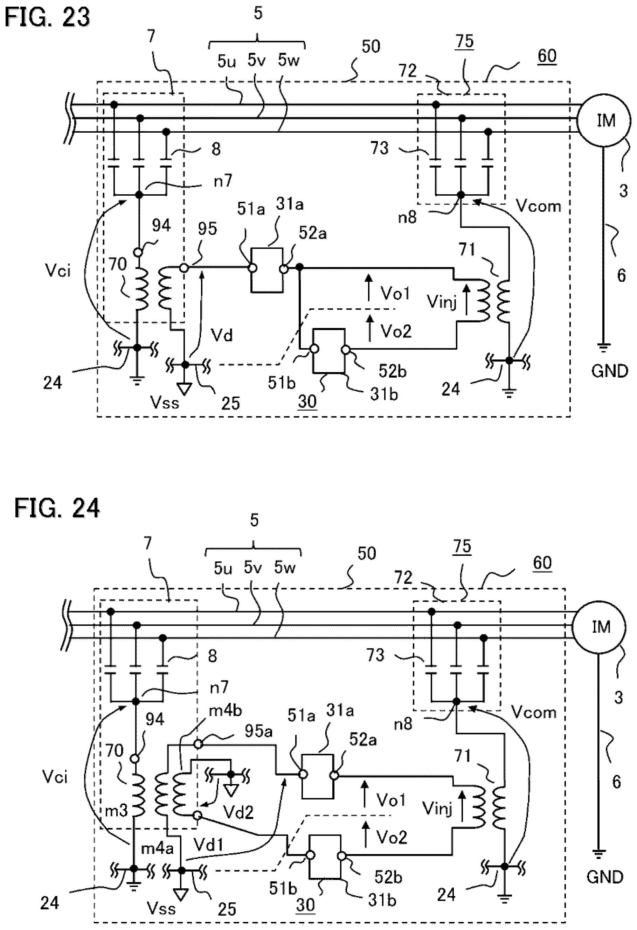

FIG. 22 shows the configuration of a first noise filter and an electric motor driving system according to Embodiment 4, and FIG. 23 shows the configuration of a second noise filter and an electric motor driving system according to Embodiment 4. FIG. 24 shows the configuration of a third noise filter and an electric motor driving system according to Embodiment 4. As in Embodiment 1, the noise filter 50 of Embodiment 4 is applicable to the electric motor driving system 60 which is a system for controlling the induction electric motor 3 by the power converter 2 such as a voltage-type PWM inverter in which a plurality of semiconductor elements perform switching operations.

The noise filter 50 of Embodiment 4 is different from the noise filter 50 of Embodiment 1 in that the noise detector 7 includes the voltage division transformer 70 instead of the signal adjustment circuit 9, and the signal adjustment transformer 71 and the signal applicator 72 are provided instead of the transformer 11. The noise filter 50 of Embodiment 4 is different from the noise filter 50 of Embodiment 2 in that the signal adjustment transformer 71 and the signal applicator 72 are provided instead of the transformer 11. Difference from the noise filter 50 of Embodiment 2 will be mainly described. In FIG. 22, a case where the noise detector 7 and the signal applicator 72 are connected to the three-phase power lines 5 is shown.

The output voltage Vo1 outputted from the output terminal 52a of the injection waveform generator 31a is inputted to one end of the primary-side winding m5 of the signal adjustment transformer 71. The output voltage Vo2 outputted from the output terminal 52b of the injection waveform generator 31b is inputted to another end of the primary-side winding m5 of the signal adjustment transformer 71. The output voltage Vo1 and the output voltage Vo2 are voltages having the same magnitude and opposite phases.

That is, the output voltage Vo1 and the output voltage Vo2 are voltages having the same magnitude and opposite polarities. On the primary-side winding m5 of the signal adjustment transformer 71, a difference between the output voltage Vo1 and the output voltage Vo2, i.e., the injection voltage Vinj which is voltage that is two times Vo1 and has the same phase, namely, the same polarity as Vo1, is applied. The compensation voltage Vcom is superimposed on the three-phase power lines 5 for the respective phases via the capacitors 73 of the signal applicator 72 so as to reduce the common mode voltage Vci. Then, current for reducing the common mode voltage Vci flows through the three-phase power line 5 for each phase via the capacitor 73 of the signal applicator 72.

In the first noise filter 50 of Embodiment 4, since the injection waveform generator 31a and the injection waveform generator 31b output the output voltages Vo1, Vo2 having the same magnitude and opposite phases, a difference between the output voltage Vo1 and the output voltage Vo2, i.e., the injection voltage Vinj that is two times Vo1 and has the same phase as Vo1, is applied on the primary-side winding m5 of the signal adjustment transformer 71.

That is, in the first noise filter 50 of Embodiment 4, the injection voltage Vinj whose maximum voltage is two times the voltage of the control power supplies 15a, 15b as shown by Expression (6) is obtained without increasing the output voltage Vo outputted by one injection waveform generator 31, i.e., without increasing the output voltage Vo1, Vo2 of each injection waveform generator 31a, 31b. As a result, the size of the signal adjustment transformer 71 or the control power supplies 15a, 15b can be reduced. Thus, the first noise filter 50 of Embodiment 4 can reduce the common mode voltage Vci while having a reduced size and a reduced weight, i.e., can have an enhanced noise reduction effect while having a reduced size and a reduced weight.

As in the second noise filter 50 of Embodiment 4 shown in FIG. 23, for example, the adjusted voltage Vd outputted from the noise detector 7 may be inputted to only the first injection waveform generator 31a, the output terminal 52a of the first injection waveform generator 31a may be connected to one end of the primary-side winding m5 of the signal adjustment transformer 71 and the input terminal 51b of the second injection waveform generator 3 1b, and the output terminal 52b of the second injection waveform generator 31b may be connected to another end of the primary-side winding m5 of the signal adjustment transformer 71. Also in this case, the output voltage Vo1 of the first injection waveform generator 31a and the output voltage Vo2 of the second injection waveform generator 31b are voltages having the same magnitude and opposite phases.

In the second noise filter 50 of Embodiment 4, as in the second noise filter 50 of Embodiment 2, the second injection waveform generator 31b receives Vo1 outputted from the first injection waveform generator 31a. In order to output the output voltage Vo2 having the same magnitude as and a phase opposite to the output voltage Vo1, the second injection waveform generator 31b has such a circuit that turns the phase of the input signal by 180° with a gain of factor 1. That is, the gain Gi of the operational amplifier 19 of the second injection waveform generator 3 1b is -1 in a case where the gain Gi of the first injection waveform generator 31a is positive, and 1 in a case where the gain Gi of the first injection waveform generator 31a is negative.

In the second noise filter 50 of Embodiment 4, the second injection waveform generator 3 1b has only to turn the phase of the input signal by 180° with a gain of factor 1, and therefore, as long as the band limiter 12 is provided in the first injection waveform generator 31a, the band limiter 12 of the second injection waveform generator 31b can be removed.

As in the third noise filter 50 of Embodiment 4 shown in FIG. 24, for example, the voltage division transformer 70 included in the noise detector 7 may have two secondary-side windings m4a, m4b, and adjusted voltages Vd1, Vd2 having the same magnitude and opposite phases may be outputted from the output terminals 95a, 95b connected to the respective secondary-side windings m4a, m4b. Then, the adjusted voltage Vd1 may be inputted to the first injection waveform generator 31a, and the adjusted voltage Vd2 may be inputted to the second injection waveform generator 31b.

The voltage division transformer 70 and the injection waveform generators 31a, 31b in the third noise filter 50 of Embodiment 4 are the same as the voltage division transformer 70 and the injection waveform generators 31a, 31b in the third noise filter 50 of Embodiment 2. The output voltage Vo1 of the first injection waveform generator 31a and the output voltage Vo2 of the second injection waveform generator 31b are voltages having the same magnitude and opposite phases.

Since the adjusted voltages Vd1, Vd2 have the same magnitude and opposite phases, the injection waveform generators 31a, 31b can be configured by circuits having the same gain and the same phase characteristic. That is, the same common circuits can be used, and thus error between the characteristics of the injection waveform generators 31a, 31b can be reduced.

In the third noise filter 50 of Embodiment 4, the polarities of the first secondary-side winding m4a and the second secondary-side winding m4b of the voltage division transformer 70 may be the same as or different from that of the primary-side winding m3, and the numbers of winding turns may be different. That is, the adjusted voltages Vd1, Vd2 may have different magnitudes and the same phase. In accordance with the adjusted voltages Vd1, Vd2, setting is made such that the injection waveform generators 31a, 31b to which the adjusted voltages Vd1, Vd2 are inputted respectively output the output voltages Vo1, Vo2 having the same magnitude and opposite phases. Thus, as in the first noise filter 50 of Embodiment 4, in the third noise filter 50 of Embodiment 4, the injection voltage Vinj whose maximum voltage is two times the voltage of the control power supplies 15a, 15b is obtained without increasing the output voltage Vo outputted by one injection waveform generator 31, i.e., without increasing the output voltage Vo1, Vo2 of each injection waveform generator 31a, 31b. As a result, in the third noise filter 50 of Embodiment 4, the size of the signal adjustment transformer 71 or the control power supplies 15a, 15b can be reduced, whereby the size and the weight of the noise filter 50 can be reduced.

In Embodiment 4, a case where the output voltage Vo1 and the output voltage Vo2 have the same magnitude has been shown. However, as in Embodiment 1, the output voltage Vo1 and the output voltage Vo2 may have different magnitudes. Also in a case where their magnitudes are different, a difference between the output voltage Vo1 and the output voltage Vo2, i.e., the injection voltage Vinj which is greater than Vo1 and has the same phase as Vo1, is applied on the primary-side winding m5 of the signal adjustment transformer 71. As a result, in the noise filter 50 of Embodiment 4, the size of the signal adjustment transformer 71 or the control power supplies 15a, 15b can be reduced, whereby the size and the weight of the noise filter 50 can be reduced. Although the noise filter 50 of Embodiment 4 shown in FIG. 22 to FIG. 24 has a feedforward configuration, the position of the signal applicator 72 and the signal adjustment transformer 71, i.e., the compensation signal applicator 75, and the position of the noise detector 7, may be changed to each other so as to make a feedback configuration.

Embodiment 5

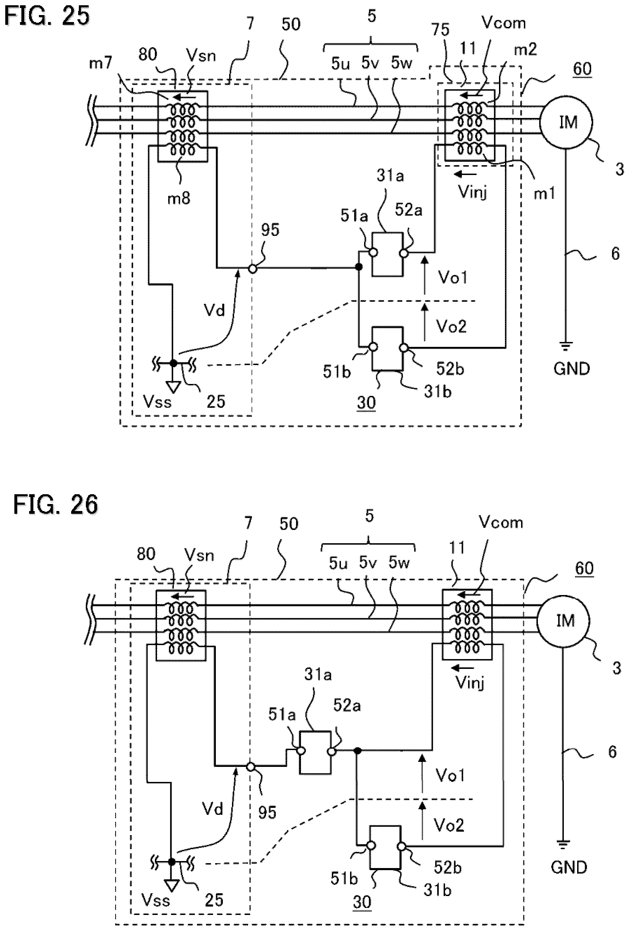

FIG. 25 shows the configuration of a first noise filter and an electric motor driving system according to Embodiment 5, and FIG. 26 shows the configuration of a second noise filter and an electric motor driving system according to Embodiment 5.

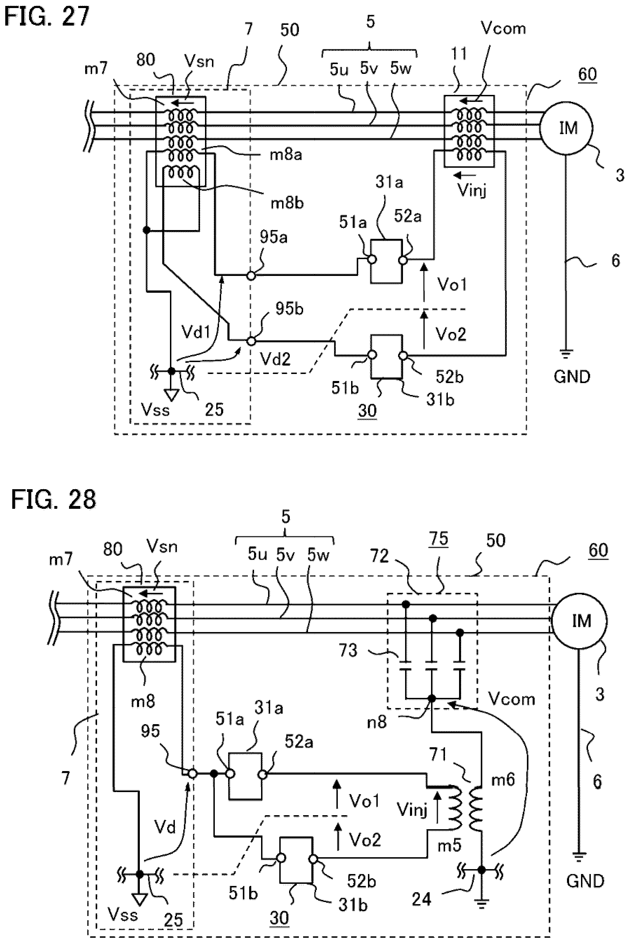

FIG. 27 shows the configuration of a third noise filter and an electric motor driving system according to Embodiment 5. As in Embodiment 1, the noise filter 50 of Embodiment 5 is applicable to the electric motor driving system 60 which is a system for controlling the induction electric motor 3 by the power converter 2 such as a voltage-type PWM inverter in which a plurality of semiconductor elements perform switching operations.

The noise filter 50 of Embodiment 5 is different from the noise filter 50 of Embodiment 1 in that the noise detector 7 includes a detection transformer 80, and the injection waveform generators are the injection waveform generator 31a and the injection waveform generator 3 1b shown in FIG. 16 to FIG. 18 as in Embodiment 2. Differences from the noise filter 50 of Embodiment 1 will be mainly described. The noise detector 7 includes the detection transformer 80 having primary-side windings m7 interposed on the three-phase power lines 5, 4 on the output side or the input side of the power converter 2. A secondary-side winding m8 of the detection transformer 80 has one end connected to the line 25 which is the reference line having the reference potential Vss, and another end connected to the output terminal 95 for outputting the adjusted voltage Vd.

As in the transformer 11, the detection transformer 80 has the primary-side windings m7 on the primary side and the secondary-side winding m8 on the secondary side, and detects voltage proportional to common mode current which is current of electromagnetic noise generated by the power converter 2, i.e., detection voltage Vsn. In FIG. 25, a case where the primary-side windings m7 of the detection transformer 80 are interposed on the three-phase power lines 5u, 5v, 5w for the respective phases of the three-phase power lines 5, is shown. One end of the secondary-side winding m8 is connected to the line 25 having the reference potential Vss, and another end of the secondary-side winding m8 is connected to the output terminal 95. In the detection transformer 80, the detection voltage Vsn applied between both ends of each primary-side winding m7 is outputted to between both ends of the secondary-side winding m8, in accordance with the turns ratio Rr of the primary-side winding m7 and the secondary-side winding m8 of the detection transformer 80, and this voltage is outputted from the output terminal 95 to the injection waveform generators 31a, 31b, as the adjusted voltage Vd which is an output of the noise detector 7.

The detection voltage Vsn detected by the detection transformer 80 will be described in detail. The common mode voltage Vci described in Embodiments 1 to 4 is voltage of a common mode component of electromagnetic noise on the three-phase power lines 5, 4. The common mode voltage Vci is noise voltage that occurs in principle on a path through power conversion being performed by the power converter 2. The common mode voltage Vci is present no matter how the detection is performed. In Embodiments 1 to 4, a case where the common mode voltage Vci is detected by an ideal capacitor-type noise detector 7, has been shown.

In a case where ground-based common mode voltage with respect to the ground GND as a reference is detected by an ideal capacitor-type noise detector, the detection voltage is equal to the common mode voltage Vci. In a case where the detection circuit is modified for a reason of an upper limit of processing voltage or the like, it is also possible to obtain a detection value different from the common mode voltage Vci. In Embodiments 1 to 4, a case where the detection circuit is modified so as to adjust the common mode voltage Vci to the adjusted voltage Vd, has been shown. The modification of the detection circuit is to intentionally cut off a low-frequency band component having a great amplitude by performing detection through a high-pass filter configuration, for example.

In a case where a common mode component of electromagnetic noise is detected by a coil-type noise detector, unlike a case of a capacitor type, voltage reduction proportional to the value of noise current (not shown) flowing through a common mode path including a coil due to application of the common mode voltage Vci on the common mode path, occurs. The voltage reduction through the primary-side winding m7, proportional to the value of the noise current, corresponds to the detection voltage Vsn.

On the secondary-side winding m8 of the detection transformer 80, voltage having a value multiplied by the turns ratio of the primary-side winding m7 and the secondary-side winding m8 is generated, and this voltage becomes the adjusted voltage Vd outputted from the noise detector 7 which is the coil-type noise detector. The voltage generated on the secondary-side winding m8 of the detection transformer 80 is a physical quantity different from the common mode voltage Vci, and is voltage based on the detection voltage Vsn proportional to the value of noise current.

The output voltage Vo1 outputted from the injection waveform generator 31a and the output voltage Vo2 outputted from the injection waveform generator 31b are voltages having the same magnitude and opposite phases, and are respectively applied to one end and another end of the primary-side winding m1 of the transformer 11, whereby the injection voltage Vinj corresponding to the difference is applied. In the transformer 11, the compensation voltage Vcom is generated between both ends of each secondary-side winding m2 in accordance with the turns ratio Rr, whereby the compensation voltage Vcom is applied on the three-phase power lines 5 for the respective phases. In the noise filter 50 of Embodiment 5, the gain Gi and the turns ratio Rr are set so that the compensation voltage Vcom which is voltage superimposed on each of the three-phase power line 5 for u phase, v phase, and w phase via the secondary-side windings m2 of the transformer 11 reduces the detection voltage Vsn, i.e., Expression (9) is satisfied.

$$|Vsn-Vcom| \leq Vto \qquad \ldots (9)$$

As previously described, Vto is an allowable value for a voltage difference. Expression (9) indicates that the absolute value of a difference between the detection voltage Vsn and the compensation voltage Vcom is the allowable value Vto or less.

As in the noise filter 50 of Embodiment 1, in the noise filter 50 of Embodiment 5, the injection voltage Vinj whose maximum voltage is two times the voltage of the control power supplies 15a, 15b is obtained without increasing the output voltage Vo outputted by one injection waveform generator 31, i.e., without increasing the output voltage Vo1, Vo2 of each injection waveform generator 31a, 31b. As a result, in the noise filter 50 of Embodiment 5, the size of the transformer 11 or the control power supplies 15a, 15b can be reduced, whereby the size and the weight of the noise filter 50 can be reduced. Thus, the first noise filter 50 of Embodiment 5 can reduce common mode current which is current of electromagnetic noise while having a reduced size and a reduced weight, i.e., can have an enhanced noise reduction effect while having a reduced size and a reduced weight.

As in the second noise filter 50 of Embodiment 5 shown in FIG. 26, for example, the adjusted voltage Vd outputted from the noise detector 7 may be inputted to only the first injection waveform generator 31a, the output terminal 52a of the first injection waveform generator 31a may be connected to one end of the primary-side winding m1 of the transformer 11 and the input terminal 51b of the second injection waveform generator 31b, and the output terminal 52b of the second injection waveform generator 31b may be connected to another end of the primary-side winding m1 of the transformer 11. Also in this case, the output voltage Vo1 of the first injection waveform generator 31a and the output voltage Vo2 of the second injection waveform generator 31b are voltages having the same magnitude and opposite phases.

In the second noise filter 50 of Embodiment 5, as in the fourth noise filter 50 of Embodiment 1, the second injection waveform generator 31b receives Vo1 outputted from the first injection waveform generator 31a. In order to output the output voltage Vo2 having the same magnitude as and a phase opposite to the output voltage Vo1, the second injection waveform generator 31b has such a circuit that turns the phase of the input signal by 180° with a gain of factor 1. That is, the gain Gi of the operational amplifier 19 of the second injection waveform generator 31b is -1 in a case where the gain Gi of the first injection waveform generator 31a is positive, and 1 in a case where the gain Gi of the first injection waveform generator 31a is negative.

In the second noise filter 50 of Embodiment 5, the second injection waveform generator 31b has only to turn the phase of the input signal by 180° with a gain of factor 1, and therefore, as long as the band limiter 12 is provided in the first injection waveform generator 31a, the band limiter 12 of the second injection waveform generator 31b can be removed.

As in the third noise filter 50 of Embodiment 5 shown in FIG. 27, for example, the detection transformer 80 included in the noise detector 7 may have two secondary-side windings m8a, m8b, and adjusted voltages Vd1, Vd2 having the same magnitude and opposite phases may be outputted from the output terminals 95a, 95b connected to the respective secondary-side windings m8a, m8b. Then, the adjusted voltage Vd1 may be inputted to the first injection waveform generator 31a, and the adjusted voltage Vd2 may be inputted to the second injection waveform generator 31b. Also in this case, the output voltage Vo1 of the first injection waveform generator 31a and the output voltage Vo2 of the second injection waveform generator 31b are voltages having the same magnitude and opposite phases.

Since the adjusted voltages Vd1, Vd2 have the same magnitude and opposite phases, the injection waveform generators 31a, 31b can be configured by circuits having the same gain and the same phase characteristic. That is, the same common circuits can be used, and thus error between the characteristics of the injection waveform generators 31a, 31b can be reduced.

In the third noise filter 50 of Embodiment 5, the noise detector 7 includes the detection transformer 80 having the primary-side windings m7 interposed on the three-phase power lines 5, 4 on the output side or the input side of the power converter 2, and the two secondary-side windings m8a, m8b. The first secondary-side winding m8a which is one of the secondary-side windings has one end connected to the line 25 which is the reference line having the reference potential Vss, and another end connected to the first output terminal 95a for outputting the first adjusted voltage Vd1 which is the adjusted voltage for first. The second secondary-side winding m8b which is the other secondary-side winding has one end connected to the line 25 which is the reference line, and another end connected to the second output terminal 95b for outputting the second adjusted voltage Vd2 which is the adjusted voltage for second.

In the third noise filter 50 of Embodiment 5, the injection voltage generator 30 includes the first injection waveform generator 31a which generates the first output voltage Vo1 on the basis of the first adjusted voltage Vd1, and the second injection waveform generator 31b which generates the second output voltage Vo2 on the basis of the second adjusted voltage Vd2. As a result, in the third noise filter 50 of Embodiment 5, the size of the transformer 11 or the control power supplies 15a, 15b can be reduced, whereby the size and the weight of the noise filter 50 can be reduced.

In the third noise filter 50 of Embodiment 5, the polarities of the first secondary-side winding m8a and the second secondary-side winding m8b of the detection transformer 80 may be the same as or different from that of the primary-side winding m7, and the numbers of winding turns may be different. That is, the adjusted voltages Vd1, Vd2 may have different magnitudes and the same phase. In accordance with the adjusted voltages Vd1, Vd2, setting is made such that the injection waveform generators 31a, 31b to which the adjusted voltages Vd1, Vd2 are inputted respectively output the output voltages Vo1, Vo2 having the same magnitude and opposite phases.

Thus, as in the first noise filter 50 of Embodiment 5, in the third noise filter 50 of Embodiment 5, the injection voltage Vinj whose maximum voltage is two times the voltage of the control power supplies 15a, 15b is obtained without increasing the output voltage Vo outputted by one injection waveform generator 31, i.e., without increasing the output voltage Vo1, Vo2 of each injection waveform generator 31a, 31b. As a result, in the third noise filter 50 of Embodiment 5, the size of the transformer 11 or the control power supplies 15a, 15b can be reduced, whereby the size and the weight of the noise filter 50 can be reduced.

In Embodiment 5, a case where the output voltage Vo1 and the output voltage Vo2 have the same magnitude has been shown. However, as in Embodiment 1, the output voltage Vo1 and the output voltage Vo2 may have different magnitudes. Also in a case where their magnitudes are different, a difference between the output voltage Vo1 and the output voltage Vo2, i.e., the injection voltage Vinj which is voltage greater than the output voltage Vo1 and having the same phase as the output voltage Vo1, is applied on the primary-side winding m1 of the transformer 11.

As a result, in the noise filter 50 of Embodiment 5, the size of the transformer 11 or the control power supplies 15a, 15b can be reduced, whereby the size and the weight of the noise filter 50 can be reduced. Although the noise filter 50 of Embodiment 5 shown in FIG. 25 to FIG. 27 has a feedforward configuration, the positions of the transformer 11 and the noise detector 7 may be changed to each other so as to make a feedback configuration.

As described above, the noise filter 50 of Embodiment 5 is a noise filter that reduces voltage or current of electromagnetic noise generated by the power converter 2 performing power conversion through switching operations of the semiconductor elements Q1 to Q6. The noise filter 50 includes: the noise detector 7 which detects voltage (detection voltage Vsn) based on electromagnetic noise generated by the power converter 2 and outputs the adjusted voltage Vd obtained by adjusting the voltage (detection voltage Vsn) based on the electromagnetic noise; the compensation signal applicator 75 which superimposes the compensation voltage Vcom having a polarity opposite to the voltage (detection voltage Vsn) based on the electromagnetic noise, on an output or an input of the power converter 2 via the transformer 11; and the injection voltage generator 30 which generates, on the basis of the adjusted voltage Vd, the first output voltage Vo1 and the second output voltage Vo2 having a polarity opposite to the first output voltage Vo1, for generating the injection voltage Vinj between one end and another end of the primary-side winding m1 of the transformer 11, and which outputs the first output voltage Vo1 to the one end of the primary-side winding m1 of the transformer 11 and outputs the second output voltage Vo2 to the other end of the primary-side winding m1 of the transformer 11.

The injection voltage generator 30 generates the first output voltage Vo1 and the second output voltage Vo2 for generating the injection voltage Vinj so that a difference between the compensation voltage Vcom superimposed by the compensation signal applicator 75 and the voltage (detection voltage Vsn) based on the electromagnetic noise becomes the allowable value Vto or less. The noise detector 7 includes the detection transformer 80 having the primary-side windings m7 interposed on the power lines (three-phase power lines 5, 4) on the output side or the input side of the power converter 2, and the secondary-side winding m8 of the detection transformer 80 has one end connected to the reference line (line 25) having the reference potential Vss, and another end connected to the output terminal 95 for outputting the adjusted voltage Vd.

With this configuration, in the noise filter 50 of Embodiment 5, the first output voltage Vo1 and the second output voltage Vo2 having a polarity opposite to the first output voltage Vo1 are applied to both ends of the primary-side winding m1 of the transformer 11 of the compensation signal applicator 75, and the compensation voltage Vcom is superimposed on the output or the input of the power converter 2 on the basis of the injection voltage Vinj having the same polarity as the first output voltage Vo1 and greater than the first output voltage Vo1. Thus, the noise filter 50 can have an enhanced noise reduction effect while having a reduced size and a reduced weight.

Embodiment 6

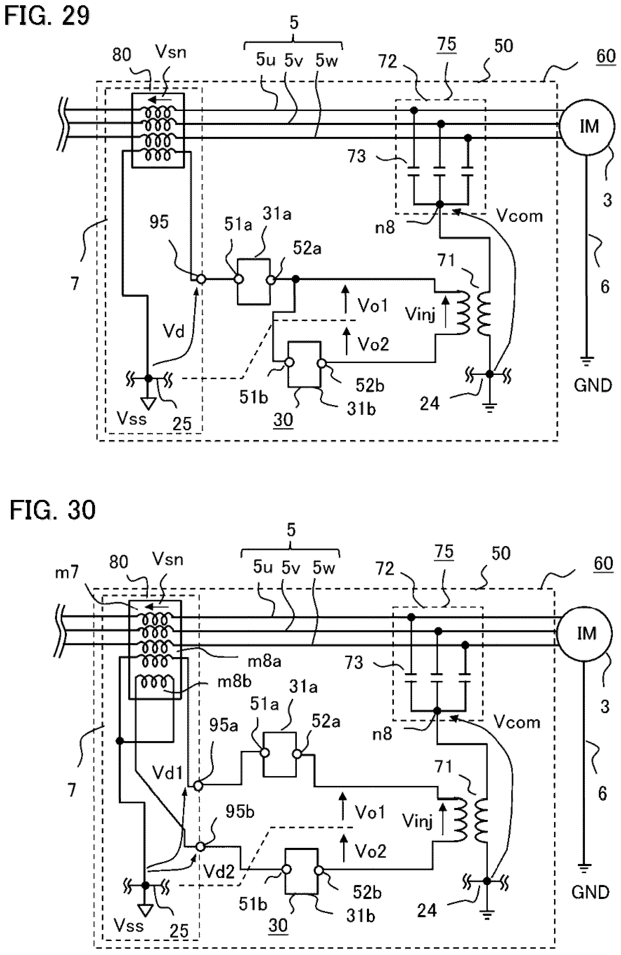

FIG. 28 shows the configuration of a first noise filter and an electric motor driving system according to Embodiment 6, and FIG. 29 shows the configuration of a second noise filter and an electric motor driving system according to Embodiment 6. FIG. 30 shows the configuration of a third noise filter and an electric motor driving system according to Embodiment 6. As in Embodiment 1, the noise filter 50 of Embodiment 6 is applicable to the electric motor driving system 60 which is a system for controlling the induction electric motor 3 by the power converter 2 such as a voltage-type PWM inverter in which a plurality of semiconductor elements perform switching operations.

The noise filter 50 of Embodiment 6 is different from the noise filter 50 of Embodiment 1 in that the noise detector 7 includes the detection transformer 80, the injection waveform generators are the injection waveform generator 31a and the injection waveform generator 31b shown in FIG. 16 to FIG. 18 as in Embodiment 2, and the signal adjustment transformer 71 and the signal applicator 72 are provided instead of the transformer 11. The noise filter 50 of Embodiment 6 is different from the noise filter 50 of Embodiment 5 in that the signal adjustment transformer 71 and the signal applicator 72 are provided instead of the transformer 11. Differences from the noise filter 50 of Embodiment 5 will be mainly described. In FIG. 28, a case where the noise detector 7 and the signal applicator 72 are connected to the three-phase power lines 5 is shown.

The output voltage Vo1 outputted from the output terminal 52a of the injection waveform generator 31a is inputted to one end of the primary-side winding m5 of the signal adjustment transformer 71. The output voltage Vo2 outputted from the output terminal 52b of the injection waveform generator 31b is inputted to another end of the primary-side winding m5 of the signal adjustment transformer 71. The output voltage Vo1 and the output voltage Vo2 are voltages having the same magnitude and opposite phases. That is, the output voltage Vo1 and the output voltage Vo2 are voltages having the same magnitude and opposite polarities.

On the primary-side winding m5 of the signal adjustment transformer 71, a difference between the output voltage Vo1 and the output voltage Vo2, i.e., the injection voltage Vinj which is voltage that is two times Vo1 and has the same phase, namely, the same polarity as Vo1, is applied. The compensation voltage Vcom is superimposed on the three-phase power lines 5 for the respective phases via the capacitors 73 of the signal applicator 72 so as to reduce common mode current which is current of electromagnetic noise, i.e., reduce the detection voltage Vsn which is voltage based on electromagnetic noise. Then, current for reducing the detection voltage Vsn which is voltage based on electromagnetic noise flows through the three-phase power line 5 for each phase via the capacitor 73 of the signal applicator 72.

The first noise filter 50 of Embodiment 6 includes the injection waveform generator 31a and the injection waveform generator 31b, and the injection waveform generator 31a and the injection waveform generator 31b output the output voltage Vo1 and the output voltage Vo2 having the same magnitude and opposite phases. Therefore, a difference between the output voltage Vo1 and the output voltage Vo2, i.e., the injection voltage Vinj that is two times Vo1 and has the same phase as Vo1, is applied on the primary-side winding m5 of the signal adjustment transformer 71.

That is, in the first noise filter 50 of Embodiment 6, the injection voltage Vinj whose maximum voltage is two times the voltage of the control power supplies 15a, 15b as shown by Expression (6) is obtained without increasing the output voltage Vo outputted by one injection waveform generator 31, i.e., without increasing the output voltage Vo1, Vo2 of each injection waveform generator 31a, 31b. As a result, in the first noise filter 50 of Embodiment 6, the size of the signal adjustment transformer 71 or the control power supplies 15a, 15b can be reduced, and common mode current which is current of electromagnetic noise can be reduced with the noise filter 50 having a reduced size and a reduced weight. Thus, the first noise filter 50 of Embodiment 6 can reduce common mode current which is current of electromagnetic noise, while having a reduced size and a reduced weight, i.e., can have an enhanced noise reduction effect while having a reduced size and a reduced weight.

As in the second noise filter 50 of Embodiment 6 shown in FIG. 29, for example, the adjusted voltage Vd outputted from the noise detector 7 may be inputted to only the first injection waveform generator 31a, the output terminal 52a of the first injection waveform generator 31a may be connected to one end of the primary-side winding m5 of the signal adjustment transformer 71 and the input terminal 51b of the second injection waveform generator 31b, and the output terminal 52b of the second injection waveform generator 31b may be connected to another end of the primary-side winding m5 of the signal adjustment transformer 71. Also in this case, the output voltage Vo1 of the first injection waveform generator 31a and the output voltage Vo2 of the second injection waveform generator 31b are voltages having the same magnitude and opposite phases.

In the second noise filter 50 of Embodiment 6, as in the second noise filter 50 of Embodiment 5, the second injection waveform generator 31b receives Vo1 outputted from the first injection waveform generator 31a. In order to output the output voltage Vo2 having the same magnitude as and a phase opposite to the output voltage Vo1, the second injection waveform generator 31b has such a circuit that turns the phase of the input signal by 180° with a gain of factor 1. That is, the gain Gi of the operational amplifier 19 of the second injection waveform generator 31b is -1 in a case where the gain Gi of the first injection waveform generator 31a is positive, and 1 in a case where the gain Gi of the first injection waveform generator 31a is negative.

In the second noise filter 50 of Embodiment 6, the second injection waveform generator 31b has only to turn the phase of the input signal by 180° with a gain of factor 1, and therefore, as long as the band limiter 12 is provided in the first injection waveform generator 31a, the band limiter 12 of the second injection waveform generator 31b can be removed.

As in the third noise filter 50 of Embodiment 6 shown in FIG. 30, for example, the detection transformer 80 included in the noise detector 7 may have two secondary-side windings m8a, m8b, and adjusted voltages Vd1, Vd2 having the same magnitude and opposite phases may be outputted from the output terminals 95a, 95b connected to the respective secondary-side windings m8a, m8b. Then, the adjusted voltage Vd1 may be inputted to the first injection waveform generator 31a, and the adjusted voltage Vd2 may be inputted to the second injection waveform generator 31b. The detection transformer 80 and the injection waveform generators 31a, 31b in the third noise filter 50 of Embodiment 6 are the same as the detection transformer 80 and the injection waveform generators 31a, 31b in the third noise filter 50 of Embodiment 5. The output voltage Vo1 of the first injection waveform generator 31a and the output voltage Vo2 of the second injection waveform generator 31b are voltages having the same magnitude and opposite phases.

Since the adjusted voltages Vd1, Vd2 have the same magnitude and opposite phases, the injection waveform generators 31a, 31b can be configured by circuits having the same gain and the same phase characteristic. That is, the same common circuits can be used, and thus error between the characteristics of the injection waveform generators 31a, 31b can be reduced.

In the third noise filter 50 of Embodiment 6, the polarities of the first secondary-side winding m8a and the second secondary-side winding m8b of the detection transformer 80 may be the same as or different from that of the primary-side winding m7, and the numbers of winding turns may be different. That is, the adjusted voltages Vd1, Vd2 may have different magnitudes and the same phase. In accordance with the adjusted voltages Vd1, Vd2, setting is made such that the injection waveform generators 31a, 31b to which the adjusted voltages Vd1, Vd2 are inputted respectively output the output voltages Vo1, Vo2 having the same magnitude and opposite phases.

Thus, as in the first noise filter 50 of Embodiment 6, in the third noise filter 50 of Embodiment 6, the injection voltage Vinj whose maximum voltage is two times the voltage of the control power supplies 15a, 15b is obtained without increasing the output voltage Vo outputted by one injection waveform generator 31, i.e., without increasing the output voltage Vo1, Vo2 of each injection waveform generator 31a, 31b. As a result, in the third noise filter 50 of Embodiment 6, the size of the signal adjustment transformer 71 or the control power supplies 15a, 15b can be reduced, whereby the size and the weight of the noise filter 50 can be reduced.

In Embodiment 6, a case where the output voltage Vo1 and the output voltage Vo2 have the same magnitude has been shown. However, as in Embodiment 1, the output voltage Vo1 and the output voltage Vo2 may have different magnitudes. Also in a case where their magnitudes are different, a difference between the output voltage Vo1 and the output voltage Vo2, i.e., the injection voltage Vinj which is greater than Vo1 and has the same phase as Vo1, is applied on the primary-side winding m5 of the signal adjustment transformer 71. As a result, in the noise filter 50 of Embodiment 6, the size of the signal adjustment transformer 71 or the control power supplies 15a, 15b can be reduced, whereby the size and the weight of the noise filter 50 can be reduced. Although the noise filter 50 of Embodiment 6 shown in FIG. 28 to FIG. 30 has a feedforward configuration, the position of the signal applicator 72 and the signal adjustment transformer 71, i.e., the compensation signal applicator 75, and the position of the noise detector 7, may be changed to each other so as to make a feedback configuration.

Embodiment 7

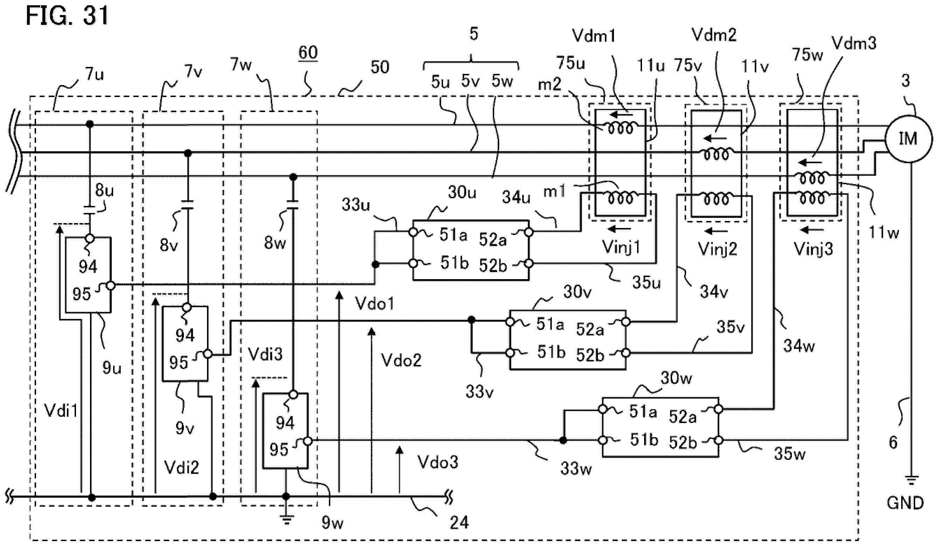

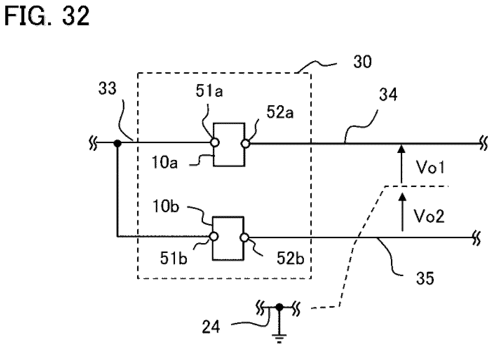

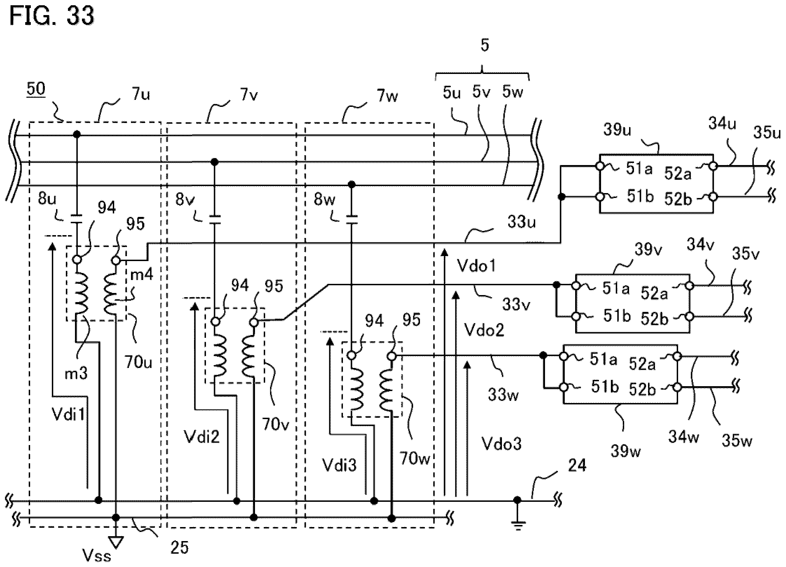

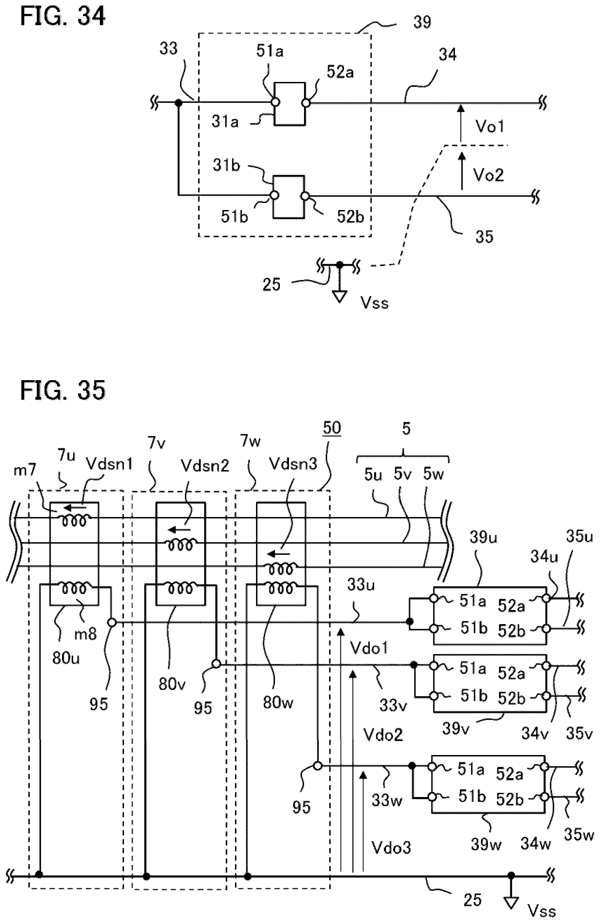

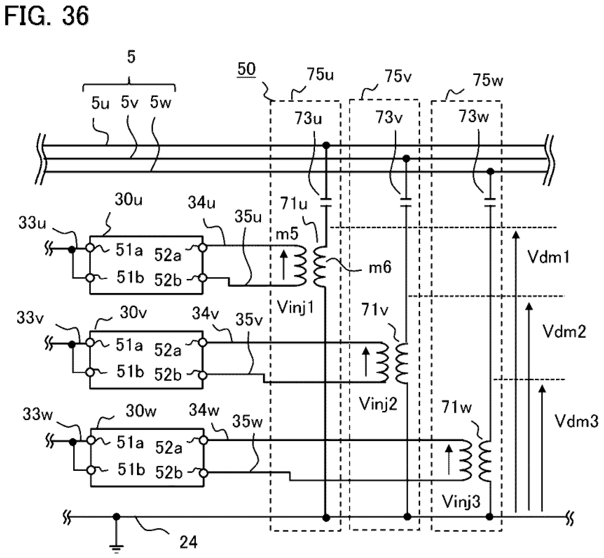

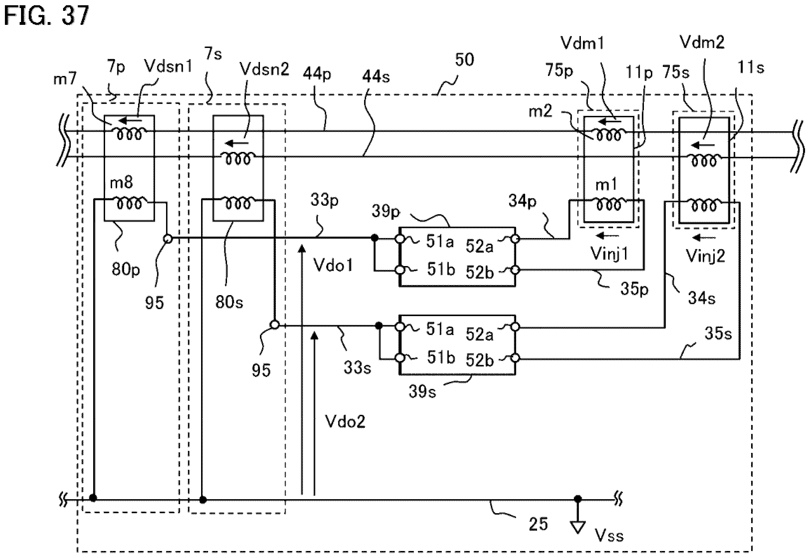

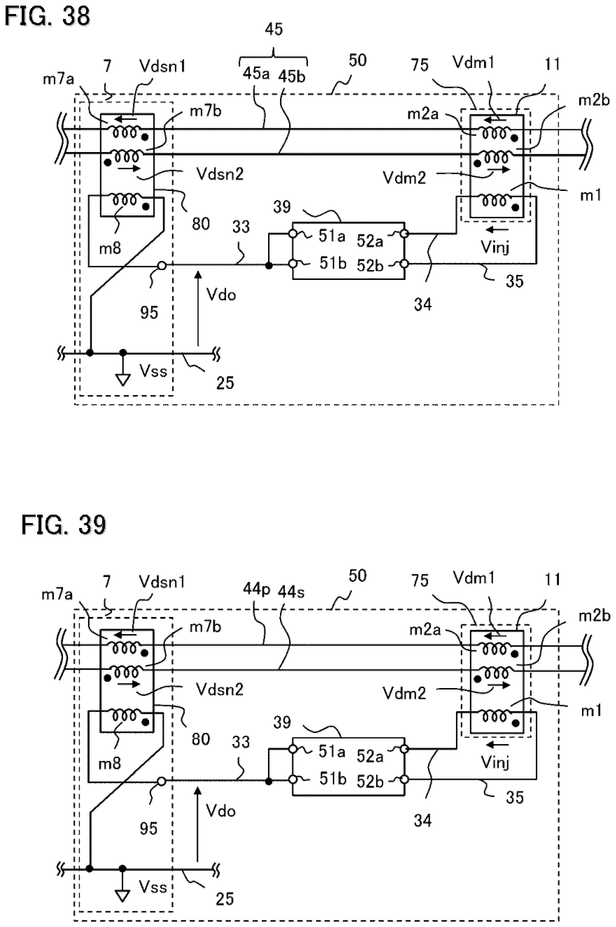

FIG. 31 shows the configuration of a first noise filter and an electric motor driving system according to Embodiment 7, and FIG. 32 shows an injection waveform generator shown in FIG. 31. FIG. 33 shows the configuration of a second noise filter according to Embodiment 7, and FIG. 34 shows an injection waveform generator shown in FIG. 33. FIG. 35 shows the configuration of a third noise filter according to Embodiment 7, and FIG. 36 shows the configuration of a fourth noise filter according to Embodiment 7. FIG. 37 shows the configuration of a fifth noise filter according to Embodiment 7. FIG. 38 shows the configuration of a sixth noise filter according to Embodiment 7, and FIG. 39 shows the configuration of a seventh noise filter according to Embodiment 7. As in Embodiment 1, the noise filter 50 of Embodiment 7 is applicable to the electric motor driving system 60 which is a system for controlling the induction electric motor 3 by the power converter 2 such as a voltage-type PWM inverter in which a plurality of semiconductor elements perform switching operations.

The noise filter 50 of each of Embodiments 1 to 6 is the noise filter 50 for reducing voltage or current of electromagnetic noise, but the present invention is not limited thereto. Electromagnetic noise generated through switching operations of semiconductor elements can include a differential mode component different from a common mode component. A differential mode component of electromagnetic noise is generated independently for each phase of the three-phase power lines 5, each phase of the three-phase power lines 4, and each line of DC buses of the power converter 2.

The DC buses of the power converter 2 are the high-potential-side line 44p and the low-potential-side line 44s. In FIG. 31, FIG. 33, FIG. 35, and FIG. 36, a case of reducing electromagnetic noise for each phase of the three-phase power lines 5 is shown. In FIG. 37 and FIG. 39, a case of reducing electromagnetic noise for each line of the DC buses of the power converter 2 is shown. In FIG. 38, a case of reducing electromagnetic noise for two lines of single-phase power lines 45 is shown. In Embodiment 7, examples of the noise filter 50 for detecting and reducing voltage or current of a differential mode component of electromagnetic noise will be described.

The first noise filter 50 of Embodiment 7 is different from the noise filter 50 of Embodiment 1 in that noise detectors 7u, 7v, 7w, injection voltage generators 30u, 30v, 30w, and compensation signal applicators 75u, 75v, 75w are provided for the respective phases of the three-phase power lines 5. Differences from the noise filter 50 of Embodiment 1 will be mainly described. A configuration for reducing differential mode voltage Vdi1 on the three-phase power line 5 for u phase, i.e., the three-phase power line 5u, a configuration for reducing differential mode voltage Vdi2 on the three-phase power line 5 for v phase, i.e., the three-phase power line 5v, and a configuration for reducing differential mode voltage Vdi3 on the three-phase power line 5 for w phase, i.e., the three-phase power line 5w, are the same. As the injection voltage generators 30u, 30v, 30w, an injection voltage generator 30 shown in FIG. 32 can be adopted. The injection voltage generator 30 includes the injection waveform generators 10a, 10b described in Embodiment 1. The configuration for reducing the differential mode voltage Vdi1 on the three-phase power line 5 for u phase, i.e., the three-phase power line 5u, will be described as a representative example.

The noise detector 7u for detecting the differential mode voltage Vdi1 includes a capacitor 8u and a signal adjustment circuit 9u connected in series between the line 24 which is the ground line and the three-phase power line 5u on the output side of the power converter 2. The signal adjustment circuit 9u outputs, as output voltage, adjusted voltage Vdo1 obtained by performing voltage division, band limitation, or both of them, for the differential mode voltage Vdi1 which is input voltage between the line 24 having the ground potential and the input terminal 94. The noise detector 7u detects the differential mode voltage Vdi1, and outputs the adjusted voltage Vdo1 based on the differential mode voltage Vdi1.

Specifically, the noise detector 7u includes the capacitor 8u and the signal adjustment circuit 9u connected in series between the line 24 which is the ground line and the three-phase power line 5u on the output side of the power converter 2, and the signal adjustment circuit 9u outputs the adjusted voltage Vdo1 on the basis of the differential mode voltage Vdi1 which is input voltage inputted via the capacitor 8u.

The input terminals 51a, 51b of the injection voltage generator 30u are connected to the output terminal 95 of the signal adjustment circuit 9u via input lines 33u. The output terminal 52a of the injection voltage generator 30u is connected to one end of the primary-side winding m1 of the transformer 11u of the compensation signal applicator 75u via an output line 34u, and the output terminal 52b of the injection voltage generator 30u is connected to another end of the primary-side winding m 1 of the transformer 11u of the compensation signal applicator 75u via an output line 35u. The adjusted voltage Vdo1 is inputted to the input terminals 51a, 51b of the injection voltage generator 30u, i.e., the input terminals 51a, 51b of the injection waveform generators 10a, 10b. The injection voltage generator 30 includes the first injection waveform generator 10a which generates the first output voltage Vo1 on the basis of the adjusted voltage Vdo1, and the second injection waveform generator 10b which generates the second output voltage Vo2 on the basis of the adjusted voltage Vdo1.

The injection waveform generators 10a, 10b output, from the output terminals 52a, 52b, the output voltages Vo1, Vo2 which are voltages having undergone band limitation and voltage value amplification on the basis of the inputted adjusted voltage Vdo1. The output voltage Vo1 outputted from the output terminal 52a of the injection waveform generator 10a is inputted to one end of the primary-side winding m 1 of the transformer 11u via the output line 34u. The output voltage Vo2 outputted from the output terminal 52b of the injection waveform generator 10b is inputted to another end of the primary-side winding m1 of the transformer 11u via the output line 35u. The output voltage Vo1 and the output voltage Vo2 are voltages having the same magnitude and opposite phases.

That is, the output voltage Vo1 and the output voltage Vo2 are voltages having the same magnitude and opposite polarities. On the primary-side winding m 1 of the transformer 11u, a difference between the output voltage Vo1 and the output voltage Vo2, i.e., voltage that is two times Vo1 and has the same phase, namely, the same polarity as Vo1, is applied. In FIG. 32, input lines 33, an output line 34 connected to one end of the primary-side winding m1 of the transformer, and an output line 35 connected to another end of the primary-side winding m1 of the transformer, are shown. In the injection voltage generator 30u for u phase, the input lines 33 and the output lines 34, 35 of the injection voltage generator 30 are given a sign "u" so as to be referred to as input lines 33u and output lines 34u, 35u. Similarly, in the injection voltage generator 30v for v phase, the input lines 33 and the output lines 34, 35 of the injection voltage generator 30 are given a sign "v" so as to be referred to as input lines 33v and output lines 34v, 35v. In the injection voltage generator 30w for w phase, the input lines 33 and the output lines 34, 35 of the injection voltage generator 30 are given a sign "w" so as to be referred to as input lines 33w and output lines 34w, 35w.

The transformer 11u includes the primary-side winding m1 on the primary side and the secondary-side winding m2 on the secondary side. The secondary-side winding m2 of the transformer 11u is interposed on the three-phase power line 5u. The injection voltage Vinj 1, which is difference voltage between the output voltage Vo1 outputted from the injection waveform generator 10a of the injection voltage generator 30u and the output voltage Vo2 outputted from the injection waveform generator 10b of the injection voltage generator 30u, is applied on the primary-side winding m1 of the transformer 11u, and thus compensation voltage Vdm1 which is voltage according to the turns ratio Rr of the primary-side winding m1 and the secondary-side winding m2 and having a polarity opposite to the differential mode voltage Vdi1, is generated on the secondary-side winding m2. The compensation voltage Vdm1 is superimposition voltage superimposed on the three-phase power line 5u.

The output voltage Vo1 outputted from the injection waveform generator 10a and the output voltage Vo2 outputted from the injection waveform generator 10b are voltages having the same magnitude and opposite phases, and are respectively applied to one end and another end of the primary-side winding m 1 of the transformer 11u, whereby the injection voltage Vinj 1 corresponding to the difference is applied. In the transformer 11u, the compensation voltage Vdm1 is generated between both ends of the secondary-side winding m2 in accordance with the turns ratio Rr, whereby the compensation voltage Vdm1 is applied on the three-phase power line 5 for u phase. In the first noise filter 50 of Embodiment 7, the gain Gi and the turns ratio Rr are set so that the compensation voltage Vdm1 which is voltage superimposed on the three-phase power line 5 for u phase via the secondary-side winding m2 of the transformer 11u reduces the differential mode voltage Vdi1, i.e., Expression (10) is satisfied.

$$|Vdi1\text{-}Vdm1| \leq Vto \qquad \ldots (10)$$

As previously described, Vto is an allowable value of a voltage difference. Expression (10) indicates that the absolute value of a difference between the differential mode voltage Vdi1 and the compensation voltage Vdm1 is the allowable value Vto or less.

The configuration for reducing the differential mode voltage Vdi2 on the three-phase power line 5 for v phase, i.e., the three-phase power line 5v, is the same as the configuration for reducing the differential mode voltage Vdi1 on the three-phase power line 5u. Therefore, reference characters 7u, 8u, 9u, 30u, 33u, 34u, 35u, 75u, 11u of constituent parts are replaced with 7v, 8v, 9v, 30v, 33v, 34v, 35v, 75v, 11v, respectively. In addition, reference characters Vdi1, Vdo1, Vinj 1, Vdm1 of voltages are replaced with Vdi2, Vdo2, Vinj2, Vdm2, respectively.

The configuration for reducing the differential mode voltage Vdi3 on the three-phase power line 5 for w phase, i.e., the three-phase power line 5w, is the same as the configuration for reducing the differential mode voltage Vdi1 on the three-phase power line 5u. Therefore, reference characters 7u, 8u, 9u, 30u, 33u, 34u, 35u, 75u, 11u of constituent parts are replaced with 7w, 8w, 9w, 30w, 33w, 34w, 35w, 75w, 11w, respectively. In addition, reference characters Vdi1, Vdo1, Vinj1, Vdm1 of voltages are replaced with Vdi3, Vdo3, Vinj3, Vdm3.

As described in Embodiment 1, the output voltage Vo1 outputted from the injection waveform generator 10a of the injection voltage generator 30u, 30v, 30w and the output voltage Vo2 outputted from the injection waveform generator 10b of the injection voltage generator 30u, 30v, 30w, corresponding to each phase of the three-phase power lines 5, are voltages having the same magnitude and opposite phases, and are respectively applied to one end and another end of the primary-side winding m1 of the corresponding transformer 11u, 11v, 11w, whereby each injection voltage Vinj 1, Vinj2, Vinj3 corresponding to the difference is applied. In each transformer 11u, 11v, 11w, the compensation voltage Vdm1, Vdm2, Vdm3 is generated between both ends of the secondary-side winding m2 in accordance with the turns ratio Rr, whereby the compensation voltages Vdm1, Vdm2, Vdm3 are applied on the three-phase power lines 5 for the respective phases.

In the first noise filter 50 of Embodiment 7, as in the noise filter 50 of Embodiment 1, the injection voltages Vinj 1, Vinj2, Vinj3 whose maximum voltage is two times the voltage of the control power supplies 15a, 15b are obtained without increasing the output voltage Vo outputted by one injection waveform generator 10, i.e., without increasing the output voltage Vo1, Vo2 of each injection waveform generator 10a, 10b. As a result, in the first noise filter 50 of Embodiment 7, the sizes of the transformers 11u, 11v, 11w or the control power supplies 15a, 15b can be reduced, whereby the size and the weight of the noise filter 50 can be reduced. Thus, the first noise filter 50 of Embodiment 7 can reduce the differential mode voltages Vdi1, Vdi2, Vdi3 while having a reduced size and a reduced weight, i.e., can have an enhanced noise reduction effect while having a reduced size and a reduced weight.

As in the second noise filter 50 of Embodiment 7 shown in FIG. 33, for example, the noise detectors 7u, 7v, 7w may include voltage division transformers 70u, 70v, 70w instead of the signal adjustment circuits 9u, 9v, 9w, and injection voltage generators 39u, 39v, 39w using the reference potential Vss which is a potential separate from the ground GND, as a reference, may be provided instead of the injection voltage generators 30u, 30v, 30w using the potential of the ground GND, i.e., the ground potential, as a reference. The second noise filter 50 of Embodiment 7 is different from the noise filter 50 of Embodiment 2 in that the noise detectors 7u, 7v, 7w, the injection voltage generators 39u, 39v, 39w, and the compensation signal applicators 75u, 75v, 75w are provided for the respective phases of the three-phase power lines 5. In FIG. 33, the compensation signal applicators 75u, 75v, 75w are not shown. Differences from the noise filter 50 of Embodiment 2 and the first noise filter 50 of Embodiment 7 will be mainly described.

A configuration for reducing differential mode voltage Vdi1 on the three-phase power line 5 for u phase, i.e., the three-phase power line 5u, a configuration for reducing differential mode voltage Vdi2 on the three-phase power line 5 for v phase, i.e., the three-phase power line 5v, and a configuration for reducing differential mode voltage Vdi3 on the three-phase power line 5 for w phase, i.e., the three-phase power line 5w, are the same. As the injection voltage generators 39u, 39v, 39w, an injection voltage generator 39 shown in FIG. 34 can be adopted. The injection voltage generator 39 includes the injection waveform generators 31a, 31b described in Embodiment 2. The configuration for reducing the differential mode voltage Vdi1 on the three-phase power line 5 for u phase, i.e., the three-phase power line 5u, will be described as a representative example.

The noise detector 7u for detecting the differential mode voltage Vdi1 includes the capacitor 8u and the voltage division transformer 70u connected in series between the line 24 which is the ground line and the three-phase power line 5u on the output side of the power converter 2. The primary-side winding m3 of the voltage division transformer 70u has one end connected to one end of the capacitor 8u on the side opposite to the three-phase power line 5u via the input terminal 94, and another end connected to the line 24 which is the ground line. The secondary-side winding m4 of the voltage division transformer 70u has one end connected to the line 25 which is the reference line having the reference potential Vss different from the ground potential of the line 24 which is the ground line, and another end connected to the output terminal 95 for outputting the adjusted voltage Vdo1. In the noise detector 7u, the voltage division transformer 70u outputs the adjusted voltage Vdo1 on the basis of the differential mode voltage Vdi1 which is the input voltage inputted via the capacitor 8u.

The input terminals 5 1a, 51b of the injection voltage generator 39u are connected to the output terminal 95 of the signal adjustment circuit 9u via the input lines 33u. The output terminal 52a of the injection voltage generator 39u is connected to one end of the primary-side winding m1 of the transformer 11u of the compensation signal applicator 75u via the output line 34u, and the output terminal 52b of the injection voltage generator 39u is connected to another end of the primary-side winding m1 of the transformer 11u of the compensation signal applicator 75u via the output line 35u.

The adjusted voltage Vdo1 is inputted to the input terminals 51a, 51b of the injection voltage generator 39u, i.e., the input terminals 51a, 51b of the injection waveform generators 31a, 31b. The injection voltage generator 39 includes the first injection waveform generator 31a which generates the first output voltage Vo1 on the basis of the adjusted voltage Vdo1, and the second injection waveform generator 31b which generates the second output voltage Vo2 on the basis of the adjusted voltage Vdo1.

The injection waveform generators 31a, 31b output, from the output terminals 52a, 52b, the output voltages Vo1, Vo2 which are voltages having undergone band limitation and voltage value amplification on the basis of the inputted adjusted voltage Vdo1. The output voltage Vo1 outputted from the output terminal 52a of the injection waveform generator 31a is inputted to one end of the primary-side winding m1 of the transformer 11u via the output line 34u. The output voltage Vo2 outputted from the output terminal 52b of the injection waveform generator 31b is inputted to another end of the primary-side winding m1 of the transformer 11u via the output line 35u.

The output voltage Vo1 and the output voltage Vo2 are voltages having the same magnitude and opposite phases. That is, the output voltage Vo1 and the output voltage Vo2 are voltages having the same magnitude and opposite polarities. On the primary-side winding m1 of the transformer 11u, a difference between the output voltage Vo1 and the output voltage Vo2, i.e., voltage that is two times Vo1 and has the same phase, namely, the same polarity as Vo1, is applied. In FIG. 34, the input lines 33, the output line 34 connected to one end of the primary-side winding m1 of the transformer, and the output line 35 connected to another end of the primary-side winding m1 of the transformer, are shown.

In the injection voltage generator 39u for u phase, the input lines 33 and the output lines 34, 35 of the injection voltage generator 39 are given a sign "u" so as to be referred to as input lines 33u and output lines 34u, 35u. Similarly, in the injection voltage generator 39v for v phase, the input lines 33 and the output lines 34, 35 of the injection voltage generator 39 are given a sign "v" so as to be referred to as input lines 33v and output lines 34v, 35v. In the injection voltage generator 39w for w phase, the input lines 33 and the output lines 34, 35 of the injection voltage generator 39 are given a sign "w" so as to be referred to as input lines 33w and output lines 34w, 35w.

The injection voltage Vinj 1, which is difference voltage between the output voltage Vo1 outputted from the injection waveform generator 31a of the injection voltage generator 39u and the output voltage Vo2 outputted from the injection waveform generator 31b of the injection voltage generator 39u, is applied on the primary-side winding m1 of the transformer 11u, and thus the compensation voltage Vdm1 which is voltage according to the turns ratio of the primary-side winding m1 and the secondary-side winding m2 and having a polarity opposite to the differential mode voltage Vdi1, is generated on the secondary-side winding m2. The compensation voltage Vdm1 is superimposition voltage superimposed on the three-phase power line 5u.

The configuration for reducing the differential mode voltage Vdi2 on the three-phase power line 5 for v phase, i.e., the three-phase power line 5v, is the same as the configuration for reducing the differential mode voltage Vdi1 on the three-phase power line 5u. Therefore, reference characters 7u, 8u, 70u, 39u, 33u, 34u, 35u, 75u, 11u of constituent parts are replaced with 7v, 8v, 70v, 39v, 33v, 34v, 35v, 75v, 11v, respectively. In addition, reference characters Vdi1, Vdo1, Vinj 1, Vdm1 of voltages are replaced with Vdi2, Vdo2, Vinj2, Vdm2, respectively.

The configuration for reducing the differential mode voltage Vdi3 on the three-phase power line 5 for w phase, i.e., the three-phase power line 5w, is the same as the configuration for reducing the differential mode voltage Vdi1 on the three-phase power line 5u. Therefore, reference characters 7u, 8u, 70u, 39u, 33u, 34u, 35u, 75u, 11u of constituent parts are replaced with 7w, 8w, 70w, 39w, 33w, 34w, 35w, 75w, 11w, respectively. In addition, reference characters Vdi1, Vdo1, Vinj1, Vdm1 of voltages are replaced with Vdi3, Vdo3, Vinj3, Vdm3.

As described in Embodiment 2, the output voltage Vo1 outputted from the injection waveform generator 31a of the injection voltage generator 39u, 39v, 39w and the output voltage Vo2 outputted from the injection waveform generator 31b of the injection voltage generator 39u, 39v, 39w, corresponding to each phase of the three-phase power lines 5, are voltages having the same magnitude and opposite phases, and are respectively applied to one end and another end of the primary-side winding m1 of the corresponding transformer 11u, 11v, 11w, whereby each injection voltage Vinj 1, Vinj2, Vinj3 corresponding to the difference is applied. In each transformer 11u, 11v, 11w, the compensation voltage Vdm1, Vdm2, Vdm3 is generated between both ends of the secondary-side winding m2 in accordance with the turns ratio Rr, whereby the compensation voltages Vdm1, Vdm2, Vdm3 are applied on the three-phase power lines 5 for the respective phases.

In the second noise filter 50 of Embodiment 7, as in the noise filter 50 of Embodiment 2, the injection voltages Vinj 1, Vinj2, Vinj3 whose maximum voltage is two times the voltage of the control power supplies 15a, 15b are obtained without increasing the output voltage Vo outputted by one injection waveform generator 31, i.e., without increasing the output voltage Vo1, Vo2 of each injection waveform generator 31a, 31b. As a result, in the second noise filter 50 of Embodiment 7, the sizes of the transformers 11u, 11v, 11w or the control power supplies 15a, 15b can be reduced, whereby the size and the weight of the noise filter 50 can be reduced. Thus, the second noise filter 50 of Embodiment 7 can reduce the differential mode voltages Vdi1, Vdi2, Vdi3 while having a reduced size and a reduced weight, i.e., can have an enhanced noise reduction effect while having a reduced size and a reduced weight.

As in the third noise filter 50 of Embodiment 7 shown in FIG. 35, for example, the noise detectors 7u, 7v, 7w may include detection transformers 80u, 80v, 80w. The third noise filter 50 of Embodiment 7 is different from the noise filter 50 of Embodiment 5 in that the noise detectors 7u, 7v, 7w, the injection voltage generators 39u, 39v, 39w, and the compensation signal applicators 75u, 75v, 75w are provided for the respective phases of the three-phase power lines 5. In FIG. 35, the compensation signal applicators 75u, 75v, 75w are not shown. Differences from the noise filter 50 of Embodiment 5 and the second noise filter 50 of Embodiment 7 will be mainly described.

A configuration for reducing differential mode current in current of electromagnetic noise on the three-phase power line 5 for u phase, i.e., the three-phase power line 5u, a configuration for reducing differential mode current in current of electromagnetic noise on the three-phase power line 5 for v phase, i.e., the three-phase power line 5v, and a configuration for reducing differential mode current in current of electromagnetic noise on the three-phase power line 5 for w phase, i.e., the three-phase power line 5w, are the same. As the injection voltage generators 39u, 39v, 39w, the injection voltage generator 39 shown in FIG. 34 can be adopted. The configuration for reducing differential mode current in current of electromagnetic noise on the three-phase power line 5 for u phase, i.e., the three-phase power line 5u, will be described as a representative example.

The noise detector 7u detects current of electromagnetic noise as in the noise filter 50 of Embodiment 5. Specifically, the noise detector 7u detects current of a differential mode component of electromagnetic noise. The noise detector 7u includes the detection transformer 80u having the primary-side winding m7 interposed on the three-phase power line 5u on the output side of the power converter 2. The secondary-side winding m8 of the detection transformer 80u has one end connected to the line 25 which is the reference line having the reference potential Vss, and another end connected to the output terminal 95 for outputting the adjusted voltage Vdo1. The detection transformer 80u has the primary-side winding m7 on the primary side and the secondary-side winding m8 on the secondary side as in the transformer 11u, and detects voltage proportional to differential mode current in current of electromagnetic noise generated by the power converter 2, i.e., detection voltage Vdsn1.

The detection voltage Vdsn1 is voltage based on electromagnetic noise. Thus, the noise detector 7u detects the detection voltage Vdsn1 which is voltage based on electromagnetic noise on the three-phase power line 5 for u phase, i.e., the three-phase power line 5u. In FIG. 35, a case where the primary-side winding m7 of the detection transformer 80u is interposed on the three-phase power line 5u is shown. In the detection transformer 80u, the detection voltage Vdsn1 applied between both ends of the primary-side winding m7 is outputted to between both ends of the secondary-side winding m8, in accordance with the turns ratio Rr of the primary-side winding m7 and the secondary-side winding m8 of the detection transformer 80u, and this voltage is outputted from the output terminal 95 to the injection waveform generators 31a, 31b of the injection voltage generator 39u, as the adjusted voltage Vdo1 which is an output of the noise detector 7u.

In the injection voltage generator 39u, the output voltage Vo1 outputted from the injection waveform generator 31a and the output voltage Vo2 outputted from the injection waveform generator 31b are voltages having the same magnitude and opposite phases, and are respectively applied to one end and another end of the primary-side winding m 1 of the transformer 11u, whereby the injection voltage Vinj 1 corresponding to the difference is applied.

In the transformer 11u, the compensation voltage Vdm1 is generated between both ends of the secondary-side winding m2 in accordance with the turns ratio Rr, whereby the compensation voltage Vdm1 is applied on the three-phase power line 5 for u phase. In the third noise filter 50 of Embodiment 7, the gain Gi and the turns ratio Rr are set so that the compensation voltage Vdm1 which is voltage superimposed on the three-phase power line 5 for u phase via the secondary-side winding m2 of the transformer 11u reduces the detection voltage Vdsn1, i.e., Expression (11) is satisfied.

$$|Vdsn1\text{-}Vdm1| \le Vto \qquad \ldots (11)$$

As previously described, Vto is an allowable value of a voltage difference. Expression (11) indicates that the absolute value of a difference between the detection voltage Vdsn1 and the compensation voltage Vdm1 is the allowable value Vto or less.

The configuration for reducing differential mode current in current of electromagnetic noise on the three-phase power line 5 for v phase, i.e., the three-phase power line 5v, is the same as the configuration for reducing differential mode current in current of electromagnetic noise on the three-phase power line 5u. Therefore, reference characters 7u, 80u, 39u, 33u, 34u, 35u, 75u, 11u of constituent parts are replaced with 7v, 80v, 39v, 33v, 34v, 35v, 75v, 11v, respectively. In addition, reference characters Vdsn1, Vdo1, Vinj 1, Vdm1 of voltages are replaced with Vdsn2, Vdo2, Vinj2, Vdm2, respectively. The configuration for reducing differential mode current in current of electromagnetic noise on the three-phase power line 5 for w phase, i.e., the three-phase power line 5w, is the same as the configuration for reducing differential mode current in current of electromagnetic noise on the three-phase power line 5u.

Therefore, reference characters 7u, 80u, 39u, 33u, 34u, 35u, 75u, 11u of constituent parts are replaced with 7w, 80w, 39w, 33w, 34w, 35w, 75w, 11w, respectively. In addition, reference characters Vdsn1, Vdo1, Vinj 1, Vdm1 of voltages are replaced with Vdsn3, Vdo3, Vinj3, Vdm3, respectively.

As described in Embodiment 5, the injection voltages Vinj 1, Vinj2, Vinj3 whose maximum voltage is two times the voltage of the control power supplies 15a, 15b are obtained without increasing the output voltage Vo outputted by one injection waveform generator 31, i.e., without increasing the output voltage Vo1, Vo2 of each injection waveform generator 31a, 31b. As a result, in the third noise filter 50 of Embodiment 7, the sizes of the transformers 11u, 11v, 11w or the control power supplies 15a, 15b can be reduced, whereby the size and the weight of the noise filter 50 can be reduced. Thus, the third noise filter 50 of Embodiment 7 can reduce differential current in current of electromagnetic noise while having a reduced size and a reduced weight, i.e., can have an enhanced noise reduction effect while having a reduced size and a reduced weight.

As in the fourth noise filter 50 of Embodiment 7 shown in FIG. 36, for example, the compensation signal applicators 75u, 75v, 75w may include signal adjustment transformers 71u, 71v, 71w and capacitors 73u, 73v, 73w, instead of the transformers 11u, 11v, 11w. The fourth noise filter 50 of Embodiment 7 is different from the noise filter 50 of Embodiment 3 in that the noise detectors 7u, 7v, 7w, the injection voltage generators 30u, 30v, 30w or the injection voltage generators 39u, 39v, 39w, and the compensation signal applicators 75u, 75v, 75w, are provided for the respective phases of the three-phase power lines 5.

In FIG. 36, the noise detectors 7u, 7v, 7w are not shown, and the noise detectors 7u, 7v, 7w in any of the first to third noise filters 50 of Embodiment 7 can be adopted. In FIG. 36, the injection voltage generators 30u, 30v, 30w in a case where the noise detectors 7u, 7v, 7w in the first noise filter 50 of Embodiment 7 are adopted are shown. In a case where the noise detectors 7u, 7v, 7w in the second or third noise filter 50 of Embodiment 7 are adopted, the fourth noise filter 50 of Embodiment 7 includes the injection voltage generators 39u, 39v, 39w instead of the injection voltage generators 30u, 30v, 30w. Differences from the noise filter 50 of Embodiment 3 or 4 and the first noise filter 50 of Embodiment 7 will be mainly described.

A configuration for reducing the differential mode voltage Vdi1 or differential mode current on the three-phase power line 5 for u phase, i.e., the three-phase power line 5u, a configuration for reducing the differential mode voltage Vdi2 or differential mode current on the three-phase power line 5 for v phase, i.e., the three-phase power line 5v, a configuration for reducing the differential mode voltage Vdi3 or differential mode current on the three-phase power line 5 for w phase, i.e., the three-phase power line 5w, are the same. The configurations for reducing differential mode currents are those for a case where the noise detectors 7u, 7v, 7w in the third noise filter 50 of Embodiment 7 are applied. The configuration for reducing the differential mode voltage Vdi1 or differential mode current on the three-phase power line 5 for u phase, i.e., the three-phase power line 5u, will be described as a representative example.

The compensation signal applicator 75u includes the capacitor 73u and the signal adjustment transformer 71u which is a transformer having the primary-side winding m5 on the primary side and the secondary-side winding m6 on the secondary side. The capacitor 73u corresponds to the signal applicator 72 on the three-phase power line 5u described in Embodiment 3. The secondary-side winding m6 of the signal adjustment transformer 71u has one end connected to the line 24 which is the ground line, and another end connected to the three-phase power line 5u on the output side of the power converter 2 via the capacitor 73u.

In FIG. 36, a case where the compensation signal applicator 75u is connected to the three-phase power line 5u is shown. Regarding the signal adjustment transformer 71u, the output terminals 52a, 52b of the injection voltage generator 30u are respectively connected to both ends of the primary-side winding m5, one end of the secondary-side winding m6 is connected to the line 24 having the ground potential, and another end thereof is connected to a side of the capacitor 73u opposite to the three-phase power line 5u.

The output voltage Vo1 outputted from the output terminal 52a of the injection waveform generator 10a of the injection voltage generator 30u is inputted to one end of the primary-side winding m5 of the signal adjustment transformer 71u. The output voltage Vo2 outputted from the output terminal 52b of the injection waveform generator 10b of the injection voltage generator 30u is inputted to another end of the primary-side winding m5 of the signal adjustment transformer 71u. The output voltage Vo1 and the output voltage Vo2 are voltages having the same magnitude and opposite phases. That is, the output voltage Vo1 and the output voltage Vo2 are voltages having the same magnitude and opposite polarities. On the primary-side winding m5 of the signal adjustment transformer 71u, a difference between the output voltage Vo1 and the output voltage Vo2, i.e., the injection voltage Vinj 1 which is voltage that is two times Vo1 and has the same phase, namely, the same polarity as Vo1, is applied.

The compensation voltage Vdm1 is superimposed on the three-phase power line 5u via the capacitor 73u so as to reduce the differential mode voltage Vdi1. In a case of reducing differential mode current, the compensation voltage Vdm1 is superimposed on the three-phase power line 5u via the capacitor 73u so as to reduce the detection voltage Vdsn1 which is voltage proportional to differential mode current. Then, current for reducing the differential mode voltage Vdi1 or differential mode current flows through the three-phase power line 5u via the capacitor 73u.

The configuration for reducing the differential mode voltage Vdi2 or differential mode current on the three-phase power line 5 for v phase, i.e., the three-phase power line 5v, is the same as the configuration for reducing the differential mode voltage Vdi1 or differential mode current on the three-phase power line 5 for u phase, i.e., the three-phase power line 5u. For the configuration for reducing the differential mode voltage Vdi2 on the three-phase power line 5v, reference characters 7u, 8u, 9u, or 70u, 30u, or 39u, 33u, 34u, 35u, 75u, 71u, 73u of constituent parts in the configuration for reducing the differential mode voltage Vdi1 on the three-phase power line 5u are replaced with 7v, 8v, 9v, or 70v, 30v, or 39v, 33v, 34v, 35v, 75v, 71v, 73v, respectively.

For the configuration for reducing differential mode current on the three-phase power line 5v, reference characters 7u, 80u, 39u, 33u, 34u, 35u, 75u, 71u, 73u of constituent parts in the configuration for reducing differential mode current on the three-phase power line 5u are replaced with 7v, 80v, 39v, 33v, 34v, 35v, 75v, 71v, 73v, respectively. In addition, reference characters Vdi1, or Vdsn1, Vdo1, Vinj1, Vdm1 of voltages are replaced with Vdi2, or Vdsn2, Vdo2, Vinj2, Vdm2, respectively.

The configuration for reducing the differential mode voltage Vdi3 or differential mode current on the three-phase power line 5 for w phase, i.e., the three-phase power line 5w, is the same as the configuration for reducing the differential mode voltage Vdi1 or differential mode current on the three-phase power line 5 for u phase, i.e., the three-phase power line 5u. For the configuration for reducing the differential mode voltage Vdi3 on the three-phase power line 5w, reference characters 7u, 8u, 9u, or 70u, 30u, or 39u, 33u, 34u, 35u, 75u, 71u, 73u of constituent parts in the configuration for reducing the differential mode voltage Vdi1 on the three-phase power line 5u are replaced with 7w, 8w, 9w, or 70w, 30w, or 39w, 33w, 34w, 35w, 75w, 71w, 73w, respectively.

For the configuration for reducing differential mode current on the three-phase power line 5w, reference characters 7u, 80u, 39u, 33u, 34u, 35u, 75u, 71u, 73u of constituent parts in the configuration for reducing differential mode current on the three-phase power line 5u are replaced with 7w, 80w, 39w, 33w, 34w, 35w, 75w, 71w, 73w, respectively. In addition, reference characters Vdi1, or Vdsn1, Vdo1, Vinj1, Vdm1 of voltages are replaced with Vdi3, or Vdsn3, Vdo3, Vinj3, Vdm3, respectively.

In the fourth noise filter 50 of Embodiment 7, the injection waveform generator 10a and the injection waveform generator 10b of the injection voltage generator 30u, 30v, 30w, or the injection waveform generator 31a and the injection waveform generator 31b of the injection voltage generator 39u, 39v, 39w, corresponding to each phase of the three-phase power lines 5, output the output voltages Vo1, Vo2 having the same magnitude and opposite phases.

Thus, a difference between the output voltage Vo1 and the output voltage Vo2, i.e., each injection voltage Vinj 1, Vinj2, Vinj3 that is two times Vo1 and has the same phase as Vo1, is applied on the primary-side winding m5 of the corresponding signal adjustment transformer 71u, 71v, 71w. That is, in the fourth noise filter 50 of Embodiment 7, as in the noise filter 50 of Embodiment 3 or 4, the injection voltage Vinj 1 whose maximum voltage is two times the voltage of the control power supplies 15a, 15b is obtained without increasing the output voltage Vo outputted by one injection waveform generator 10 or one injection waveform generator 31, i.e., without increasing the output voltage Vo1, Vo2 of each injection waveform generator 10a, 10b or each injection waveform generator 31a, 31b.

As a result, the sizes of the signal adjustment transformers 71u, 71v, 71w or the control power supplies 15a, 15b can be reduced. Thus, the fourth noise filter 50 of Embodiment 7 can reduce the differential mode voltages Vdi1, Vdi2, Vdi3 or differential mode currents while having a reduced size and a reduced weight, i.e., can have an enhanced noise reduction effect while having a reduced size and a reduced weight.

As in the fifth noise filter 50 of Embodiment 7 shown in FIG. 37, for example, a configuration for reducing a differential mode component of electromagnetic noise may be connected to each line of the DC buses of the power converter 2, i.e., the high-potential-side line 44p and the low-potential-side line 44s. The fifth noise filter 50 of Embodiment 7 is different from the noise filter 50 of Embodiment 1 in that noise detectors 7p, 7s, injection voltage generators 39p, 39s, and compensation signal applicators 75p, 75s are provided for the respective lines of the DC buses of the power converter 2. Differences from the noise filter 50 of Embodiment 1 and the third noise filter 50 of Embodiment 7 will be mainly described.

The fifth noise filter 50 of Embodiment 7 shown in FIG. 37 is for reducing differential mode current in current of electromagnetic noise on each of the high-potential-side line 44p and the low-potential-side line 44s, as in the third noise filter 50 of Embodiment 7. A configuration for reducing differential mode current in current of electromagnetic noise on the high-potential-side line 44p and a configuration for reducing differential mode current in current of electromagnetic noise on the low-potential-side line 44s, are the same. As the injection voltage generators 39p, 39s, the injection voltage generator 39 shown in FIG. 34 can be adopted. The configuration for reducing differential mode current in current of electromagnetic noise on the high-potential-side line 44p which is the DC bus of the power converter 2 will be described as a representative example.

The noise detector 7p detects current of a differential mode component of electromagnetic noise as in the third noise filter 50 of Embodiment 7. The noise detector 7p includes a detection transformer 80p having the primary-side winding m7 interposed on the high-potential-side line 44p of the power converter 2. The secondary-side winding m8 of the detection transformer 80p has one end connected to the line 25 which is the reference line having the reference potential Vss, and another end connected to the output terminal 95 for outputting the adjusted voltage Vdo1. The detection transformer 80p has the primary-side winding m7 on the primary side and the secondary-side winding m8 on the secondary side as in the detection transformer 80u, and detects voltage proportional to differential mode current in current of electromagnetic noise generated by the power converter 2, i.e., detection voltage Vdsn1.

The detection voltage Vdsn1 is voltage based on electromagnetic noise. Thus, the noise detector 7p detects the detection voltage Vdsn1 which is voltage based on electromagnetic noise on the high-potential-side line 44p of the power converter 2. In the detection transformer 80p, the detection voltage Vdsn1 applied between both ends of the primary-side winding m7 is outputted to between both ends of the secondary-side winding m8, in accordance with the turns ratio Rr of the primary-side winding m7 and the secondary-side winding m8 of the detection transformer 80p, and this voltage is outputted from the output terminal 95 to the injection waveform generators 31a, 31b of the injection voltage generator 39u, as the adjusted voltage Vdo1 which is an output of the noise detector 7p.

The input terminals 51a, 51b of the injection voltage generator 39p are connected to the output terminal 95 of the detection transformer 80p via input lines 33p. The output terminal 52a of the injection voltage generator 39p is connected to one end of the primary-side winding m 1 of a transformer 11p of the compensation signal applicator 75p via an output line 34p, and the output terminal 52b of the injection voltage generator 39p is connected to another end of the primary-side winding m1 of the transformer 11p of the compensation signal applicator 75p via an output line 35p. The adjusted voltage Vdo1 is inputted to the input terminals 51a, 51b of the injection voltage generator 39p, i.e., the input terminals 51a, 51b of the injection waveform generators 31a, 31b.

In the injection voltage generator 39p, the output voltage Vo1 outputted from the injection waveform generator 31a and the output voltage Vo2 outputted from the injection waveform generator 31b are voltages having the same magnitude and opposite phases, and are respectively applied to one end and another end of the primary-side winding m1 of the transformer 11p of the compensation signal applicator 75p, whereby the injection voltage Vinj 1 corresponding to the difference is applied.

In the transformer 11p, the compensation voltage Vdm1 is generated between both ends of the secondary-side winding m2 in accordance with the turns ratio Rr, whereby the compensation voltage Vdm1 is applied on the high-potential-side line 44p. In the fifth noise filter 50 of Embodiment 7, the gain Gi and the turns ratio Rr are set so that the compensation voltage Vdm1 which is voltage superimposed on the high-potential-side line 44p via the secondary-side winding m2 of the transformer 11p reduces the detection voltage Vdsn1, i.e., Expression (11) is satisfied.

The configuration for reducing differential mode current in current of electromagnetic noise on the low-potential-side line 44s which is the DC bus of the power converter 2 is the same as the configuration for reducing differential mode current in current of electromagnetic noise on the high-potential-side line 44p which is the DC bus of the power converter 2. Therefore, reference characters 7p, 80p, 39p, 33p, 34p, 35p, 75p, 11p of constituent parts are replaced with 7s, 80s, 39s, 33s, 34s, 35s, 75s, 11s, respectively. In addition, reference characters Vdsn1, Vdo1, Vinj 1, Vdm1 of voltages are replaced with Vdsn2, Vdo2, Vinj2, Vdm2, respectively.

As described in the third noise filter 50 of Embodiment 7, the injection voltages Vinj 1, Vinj 2 whose maximum voltage is two times the voltage of the control power supplies 15a, 15b are obtained without increasing the output voltage Vo outputted by one injection waveform generator 31, i.e., without increasing the output voltage Vo1, Vo2 of each injection waveform generator 31a, 31b. As a result, in the fifth noise filter 50 of Embodiment 7, the sizes of the transformers 11p, 11s or the control power supplies 15a, 15b can be reduced, whereby the size and the weight of the noise filter 50 can be reduced. Thus, the fifth noise filter 50 of Embodiment 7 can reduce differential current in current of electromagnetic noise while having a reduced size and a reduced weight, i.e., can have an enhanced noise reduction effect while having a reduced size and a reduced weight.

As in the sixth noise filter 50 of Embodiment 7 shown in FIG. 38, for example, a configuration for reducing a differential mode component of current of electromagnetic noise, i.e., differential mode current, may be connected to the single-phase power lines 45. The sixth noise filter 50 of Embodiment 7 is different from the third noise filter 50 of Embodiment 7 in that the sixth noise filter 50 includes one noise detector 7 having primary-side windings m7a, m7b respectively connected to two lines of the single-phase power lines 45, i.e., the single-phase power lines 45a, 45b, one injection voltage generator 39, and one compensation signal applicator 75 having secondary-side windings m2a, m2b respectively connected to the single-phase power lines 45a, 45b. In this case, the single-phase power lines 45 are an example of single-phase power lines on the output side of the power converter 2. Differences from the third noise filter 50 of Embodiment 7 will be mainly described.

The noise detector 7 is configured to be capable of detecting only a differential mode component, i.e., only current of a differential mode component of electromagnetic noise, without detecting a common mode component, on each of the two lines of the single-phase power lines 45, i.e., the single-phase power line 45a and the single-phase power line 45b. In FIG. 38, the detection transformer 80 is shown as an example of the noise detector 7. The primary-side winding m7a connected to the single-phase power line 45a and the primary-side winding m7b connected to the single-phase power line 45b have winding-turn directions opposite to each other.

The secondary-side winding m8 of the detection transformer 80 has one end connected to the line 25 which is the reference line having the reference potential Vss, and another end connected to the output terminal 95 for outputting the adjusted voltage Vdo. The detection voltages Vdsn1, Vdsn2 are voltages based on electromagnetic noise. On the secondary-side winding m8 of the

**EP 4 489 276 A1**

detection transformer 80, voltage obtained by adding the detection voltage Vdsn1 detected on the primary-side winding m7a and the detection voltage Vdsn2 detected on the primary-side winding m7b, is generated. The noise detector 7 outputs the adjusted voltage Vdo with respect to the reference potential Vss as a reference, from the output terminal 95. The adjusted voltage Vdo outputted from the noise detector 7 is the sum of the detection voltage Vdsn1 detected on the primary-side winding m7a and the detection voltage Vdsn2 detected on the primary-side winding m7b.

The compensation signal applicator 75 is configured such that only voltage based on current of a differential mode component can be applied while voltage based on current of a common mode component is not applied, on each of the two lines of the single-phase power lines 45, i.e., the single-phase power line 45a and the single-phase power line 45b. In FIG. 38, the transformer 11 is shown as an example of the compensation signal applicator 75. The secondary-side winding m2a connected to the single-phase power line 45a and the secondary-side winding m2b connected to the single-phase power line 45b have winding-turn directions opposite to each other. The injection voltage Vinj is applied on the primary-side winding m 1 of the transformer 11.

In a case where the turns ratio of the transformer 11 is 1:1, in accordance with the injection voltage Vinj, the compensation voltages Vdm1, Vdm2 equal to the injection voltage Vinj are superimposed on the single-phase power lines 45a, 45b, respectively. In this case, voltage based on current of a differential mode component, superimposed on the two lines of the single-phase power lines 45, i.e., the single-phase power line 45a and the single-phase power line 45b, is the sum of the compensation voltage Vdm1 and the compensation voltage Vdm2.

As in the third noise filter 50 of Embodiment 7, the sixth noise filter 50 of Embodiment 7 can reduce differential current in current of electromagnetic noise generated on each of the two lines of the single-phase power lines 45, while having a reduced size and a reduced weight, i.e., can have an enhanced noise reduction effect while having a reduced size and a reduced weight.

As in the seventh noise filter 50 of Embodiment 7 shown in FIG. 39, for example, a configuration for reducing a differential mode component of electromagnetic noise may be connected to the lines of the DC buses of the power converter 2, i.e., the high-potential-side line 44p and the low-potential-side line 44s. The seventh noise filter 50 of Embodiment 7 is different from the fifth noise filter 50 of Embodiment 7 in that the seventh noise filter 50 includes one noise detector 7 having the primary-side windings m7a, m7b respectively connected to the high-potential-side line 44p and the low-potential-side line 44s, one injection voltage generator 39, and one compensation signal applicator 75 having the secondary-side windings m2a, m2b respectively connected to the high-potential-side line 44p and the low-potential-side line 44s. Differences from the fifth noise filter 50 of Embodiment 7 will be mainly described.

The noise detector 7 is configured to be capable of detecting only a differential mode component, i.e., only current of a differential mode component of electromagnetic noise, without detecting a common mode component, on each of the high-potential-side line 44p and the low-potential-side line 44s. In FIG. 39, the detection transformer 80 is shown as an example of the noise detector 7. The primary-side winding m7a connected to the high-potential-side line 44p and the primary-side winding m7b connected to the low-potential-side line 44s have winding-turn directions opposite to each other. The secondary-side winding m8 of the detection transformer 80 has one end connected to the line 25 which is the reference line having the reference potential Vss, and another end connected to the output terminal 95 for outputting the adjusted voltage Vdo.

The detection voltages Vdsn1, Vdsn2 are voltages based on electromagnetic noise. On the secondary-side winding m8 of the detection transformer 80, voltage obtained by adding the detection voltage Vdsn1 detected on the primary-side winding m7a and the detection voltage Vdsn2 detected on the primary-side winding m7b, is generated. The noise detector 7 outputs the adjusted voltage Vdo with respect to the reference potential Vss as a reference, from the output terminal 95. The adjusted voltage Vdo outputted from the noise detector 7 is the sum of the detection voltage Vdsn1 detected on the primary-side winding m7a and the detection voltage Vdsn2 detected on the primary-side winding m7b.

The compensation signal applicator 75 is configured such that only voltage based on current of a differential mode component can be applied while voltage based on current of a common mode component is not applied, on each of the high-potential-side line 44p and the low-potential-side line 44s. In FIG. 39, the transformer 11 is shown as an example of the compensation signal applicator 75. The secondary-side winding m2a connected to the high-potential-side line 44p and the secondary-side winding m2b connected to the low-potential-side line 44s have winding-turn directions opposite to each other. The injection voltage Vinj is applied on the primary-side winding m1 of the transformer 11.

In a case where the turns ratio of the transformer 11 is 1:1, in accordance with the injection voltage Vinj, the compensation voltages Vdm1, Vdm2 equal to the injection voltage Vinj are superimposed on the high-potential-side line 44p and the low-potential-side line 44s, respectively. In this case, voltage based on current of a differential mode component, superimposed on the two lines of the DC buses of the power converter 2, i.e., the high-potential-side line 44p and the low-potential-side line 44s, is the sum of the compensation voltage Vdm1 and the compensation voltage Vdm2.

As in the fifth noise filter 50 of Embodiment 7, the seventh noise filter 50 of Embodiment 7 can reduce differential current in current of electromagnetic noise generated on each of the two lines of the DC buses of the power converter 2, while having a reduced size and a reduced weight, i.e., can have an enhanced noise reduction effect while having a reduced size and a reduced weight.

In Embodiment 7, a case where voltage or current of a differential mode component of electromagnetic noise is detected and reduced, has been described. The noise filter 50 of Embodiment 7 includes the noise detectors 7, 7u, 7v, 7w, 7p, 7s, the compensation signal applicators 75, 75u, 75v, 75w, 75p, 75s, and the injection voltage generators 30u, 30v, 30w (or 39u, 39v, 39w), 39, 39p, 39s for the respective phases of the three-phase power lines 5, the respective phases of the three-phase power lines 4, the respective power lines of the single-phase power lines 45, and the respective lines of the DC buses of the power converter 2, and therefore can also reduce voltage or current of a common mode component of electromagnetic noise described in Embodiments 1 to 6.

In Embodiment 7, a case where the output voltage Vo1 and the output voltage Vo2 have the same magnitude has been shown. However, as in Embodiment 1, the output voltage Vo1 and the output voltage Vo2 may have different magnitudes. Also in a case where their magnitudes are different, a difference between the output voltage Vo1 and the output voltage Vo2, i.e., each injection voltage Vinj 1, Vinj2, Vinj3, Vinj which is voltage greater than the output voltage Vo1 and having the same phase as the output voltage Vo1, is applied on the primary-side winding m1 of the corresponding transformer 11u, 11v, 11w or the primary-side winding m5 of the corresponding signal adjustment transformer 71u, 71v, 71w in the compensation signal applicators 75, 75u, 75v, 75w. As a result, in each of the first to fourth and sixth noise filters 50 of Embodiment 7, the sizes of the transformers 11, 11u, 11v, 11w, the signal adjustment transformers 71u, 71v, 71w, or the control power supplies 15a, 15b can be reduced, whereby the size and the weight of the noise filter 50 can be reduced.

Similarly, in each of the fifth and seventh noise filters 50 of Embodiment 7, also in a case where the magnitudes of the output voltage Vo1 and output voltage Vo2 are different, a difference between the output voltage Vo1 and the output voltage Vo2, i.e., each injection voltage Vinj 1, Vinj2, Vinj which is voltage greater than the output voltage Vo1 and having the same phase as the output voltage Vo1, is applied on the primary-side winding m 1 of the corresponding transformer 11, 11p, 11s in the compensation signal applicators 75, 75p, 75s. As a result, in each of the fifth and seventh noise filters 50 of Embodiment 7, the sizes of the transformers 11, 11p, 11s or the control power supplies 15a, 15b can be reduced, whereby the size and the weight of the noise filter 50 can be reduced.

Although the noise filter 50 of Embodiment 7 shown in FIG. 31, FIG. 33, FIG. 35, FIG. 36, and FIG. 38 has a feedforward configuration, the positions of the compensation signal applicators 75, 75u, 75v, 75w and the positions of the noise detectors 7, 7u, 7v, 7w may be changed to each other so as to make a feedback configuration. Although the noise filter 50 of Embodiment 7 shown in FIG. 37 and FIG. 39 has a feedforward configuration, the positions of the compensation signal applicators 75, 75p, 75s and the positions of the noise detectors 7, 7p, 7s may be changed to each other so as to make a feedback configuration.

The noise detectors 7u, 7v, 7w and the compensation signal applicators 75u, 75v, 75w may be connected to the three-phase power lines 4 on the input side of the power converter 2. The noise detector 7 and the compensation signal applicator 75 shown in FIG. 38 may be connected to the single-phase power lines 45 on the output side of the power converter 2, or may be connected to the single-phase power lines 45 on the input side of the power converter 2.

Embodiments 1 to 7 have shown a case where the noise filter 50 is applied to the electric motor driving system 60 provided with the power converter 2 which performs conversion from three-phase AC power or single-phase AC power via DC power to three-phase AC power or single-phase AC power. However, the present invention is not limited thereto. The noise filter 50 of each of Embodiments 1 to 7 is also applicable to a system provided with a power converter which generates voltage or current of electromagnetic noise through switching operation of a semiconductor element. For example, the power converter 2 may be an isolation DC-DC converter. In this case, the AC power supply 1 is a DC power supply, and the induction electric motor 3 is a DC electric motor.

Although the invention is described above in terms of various exemplary embodiments and implementations, it should be understood that the various features, aspects, and functionality described in one or more of the individual embodiments are not limited in their applicability to the particular Embodiment with which they are described, but instead can be applied, alone or in various combinations to one or more of the embodiments of the invention. It is therefore understood that numerous modifications which have not been exemplified can be devised without departing from the scope of the present invention. For example, at least one of the constituent components may be modified, added, or eliminated. At least one of the constituent components mentioned in at least one of the preferred embodiments may be selected and combined with the constituent components mentioned in another preferred embodiment.

DESCRIPTION OF THE REFERENCE CHARACTERS

2 power converter

4 three-phase power line
5 three-phase power line
7, 7u, 7v, 7w, 7p, 7s noise detector
8, 8u, 8v, 8w capacitor
9, 9u, 9v, 9w signal adjustment circuit
10, 10a, 10b injection waveform generator
11, 11u, 11v, 11w, 11p, 11s transformer
24 line (ground line)
25 line (reference line)
30, 30u, 30v, 30w injection voltage generator
31, 31a, 31b injection waveform generator
39, 39u, 39v, 39w, 39p, 39s injection voltage generator
44p high-potential-side line
44s low-potential-side line
45 single-phase power line
50 noise filter
70, 70u, 70v, 70w voltage division transformer
71, 71u, 71v, 71w signal adjustment transformer
72 signal applicator
73, 73u, 73v, 73w capacitor
75, 75u, 75v, 75w, 75p, 75s compensation signal applicator
80, 80u, 80v, 80w, 80p, 80s detection transformer
95, 95a, 95b output terminal
m1 primary-side winding
m2, m2a, m2b secondary-side winding
m3 primary-side winding
m4, m4a, m4b secondary-side winding
m5 primary-side winding
m6 secondary-side winding
m7, m7a, m7b primary-side winding
m8, m8a, m8b secondary-side winding
Q1, Q2, Q3, Q4, Q5, Q6 semiconductor element
Vci common mode voltage
Vdi1, Vdi2, Vdi3 differential mode voltage
Vd, Vd1, Vd2 adjusted voltage
Vdo, Vdo1, Vdo2, Vdo3 adjusted voltage
Vo output voltage
Vo1 output voltage (first output voltage)
Vo2 output voltage (second output voltage)
Vinj, Vinj 1, Vinj2, Vinj3 injection voltage
Vcom compensation voltage
Vdm1, Vdm2, Vdm3 compensation voltage
Vto allowable value
Vsn, Vdsn1, Vdsn2, Vdsn3 detection voltage
Vss reference potential

**Claims**

1. A noise filter that reduces voltage or current of electromagnetic noise generated by a power converter performing power conversion through switching operation of a semiconductor element, the noise filter comprising:

   a noise detector which detects voltage based on the electromagnetic noise generated by the power converter and outputs adjusted voltage obtained by adjusting the voltage based on the electromagnetic noise;
   a compensation signal applicator which superimposes compensation voltage having a polarity opposite to the voltage based on the electromagnetic noise, on an output or an input of the power converter via a transformer; and
   an injection voltage generator which generates, on the basis of the adjusted voltage, first output voltage and second output voltage having a polarity opposite to the first output voltage, for generating injection voltage between one end and another end of a primary-side winding of the transformer, and which outputs the first output voltage to the one end of the primary-side winding of the transformer and outputs the second output voltage to the other end of the primary-side winding of the transformer, wherein
   the injection voltage generator generates the first output voltage and the second output voltage for generating the injection voltage so that a difference between the compensation voltage superimposed by the compensation signal applicator and the voltage based on the electromagnetic noise becomes an allowable value or less.

2. The noise filter according to claim 1, wherein the transformer of the compensation signal applicator has a secondary-side winding interposed on a power line on an output side or an input side of the power converter.

3. The noise filter according to claim 1, wherein the compensation signal applicator includes a signal adjustment transformer which is the transformer, and a signal applicator including a capacitor, and
   a secondary-side winding of the signal adjustment transformer has one end connected to a ground line, and another end connected to a power line on an output side or an input side of the power converter via the capacitor of the signal applicator.

4. The noise filter according to any one of claims 1 to 3, wherein the noise detector includes a capacitor and a signal adjustment circuit connected in series between a ground line and a power line on an output side or an input side of the power converter, and
   the signal adjustment circuit outputs the adjusted voltage on the basis of input voltage inputted via the capacitor.

5. The noise filter according to any one of claims 1 to 3, wherein the noise detector includes a capacitor and a voltage division transformer connected in series between a ground line and a power line on an output side or an input side of the power converter,

a primary-side winding of the voltage division transformer has one end connected to one end of the capacitor on a side opposite to the power line, and another end connected to the ground line, and

a secondary-side winding of the voltage division transformer has one end connected to a reference line having a reference potential different from a ground potential of the ground line, and another end connected to an output terminal for outputting the adjusted voltage.

6. The noise filter according to any one of claims 1 to 3, wherein the noise detector includes a detection transformer having a primary-side winding interposed on a power line on an output side or an input side of the power converter, and a secondary-side winding of the detection transformer has one end connected to a reference line having a reference potential, and another end connected to an output terminal for outputting the adjusted voltage.

7. The noise filter according to any one of claims 1 to 5, wherein the injection voltage generator

includes a first injection waveform generator which generates the first output voltage on the basis of the adjusted voltage, and a second injection waveform generator which generates the second output voltage on the basis of the adjusted voltage, or

includes a first injection waveform generator which generates the first output voltage on the basis of the adjusted voltage, and a second injection waveform generator which generates the second output voltage on the basis of the first output voltage.

8. The noise filter according to claim 6, wherein the injection voltage generator

includes a first injection waveform generator which generates the first output voltage on the basis of the adjusted voltage, and a second injection waveform generator which generates the second output voltage on the basis of the adjusted voltage, or

includes a first injection waveform generator which generates the first output voltage on the basis of the adjusted voltage, and a second injection waveform generator which generates the second output voltage on the basis of the first output voltage.

9. The noise filter according to any one of claims 1 to 3, wherein the noise detector includes a detection transformer having a primary-side winding interposed on a power line on an output side or an input side of the power converter, the detection transformer having two secondary-side windings,

a first secondary-side winding which is one of the secondary-side windings has one end connected to a reference line having a reference potential, and another end connected to a first output terminal for outputting first adjusted voltage which is the adjusted voltage for first,

a second secondary-side winding which is the other of the secondary-side windings has one end connected to the reference line, and another end connected to a second output terminal for outputting second adjusted voltage which is the adjusted voltage for second, and

the injection voltage generator includes a first injection waveform generator which generates the first output voltage on the basis of the first adjusted voltage, and a second injection waveform generator which generates the second output voltage on the basis of the second adjusted voltage.

10. The noise filter according to any one of claims 1 to 3, wherein the noise detector includes a capacitor and a voltage division transformer connected in series between a ground line and a power line on an output side or an input side of the power converter,

the voltage division transformer has two secondary-side windings, and a primary-side winding of the voltage division transformer has one end connected to one end of the capacitor on a side opposite to the power line, and another end connected to the ground line,

a first secondary-side winding which is one of the secondary-side windings has one end connected to a reference line having a reference potential different from a ground potential of the ground line, and another end connected to a first output terminal for outputting first adjusted voltage which is the adjusted voltage for first,

a second secondary-side winding which is the other of the secondary-side windings has one end connected to the reference line, and another end connected to a second output terminal for outputting second adjusted voltage which is the adjusted voltage for second, and

the injection voltage generator includes a first injection waveform generator which generates the first output voltage on the basis of the first adjusted voltage, and a second injection waveform generator which generates the second output voltage on the basis of the second adjusted voltage.

**11.** The noise filter according to any one of claims 1 to 3, wherein the noise detector includes a capacitor and a signal adjustment circuit connected in series between a ground line and a power line on an output side or an input side of the power converter,

the signal adjustment circuit outputs first adjusted voltage and second adjusted voltage which are two said adjusted voltages, on the basis of input voltage inputted via the capacitor, and

the injection voltage generator includes a first injection waveform generator which generates the first output voltage on the basis of the first adjusted voltage, and a second injection waveform generator which generates the second output voltage on the basis of the second adjusted voltage.

**12.** The noise filter according to any one of claims 1 to 5, 7, 10, and 11,
wherein the noise detector detects common mode voltage in the voltage of the electromagnetic noise.

**13.** The noise filter according to any one of claims 6, 8, and 9,
wherein the noise detector detects voltage proportional to common mode current in the current of the electromagnetic noise.

**14.** The noise filter according to claim 1,
wherein the noise detector, the compensation signal applicator, and the injection voltage generator are provided correspondingly to each phase of power lines on an output side or an input side of the power converter.

**15.** The noise filter according to claim 1,
wherein the noise detector, the compensation signal applicator, and the injection voltage generator are provided correspondingly to each line of DC buses of the power converter.

**16.** The noise filter according to claim 14,
wherein the noise detector corresponding to each phase of the power lines on the output side or the input side of the power converter includes a capacitor and a signal adjustment circuit connected in series between a ground line and the corresponding power line, and
the signal adjustment circuit outputs the adjusted voltage on the basis of input voltage inputted via the capacitor.

**17.** The noise filter according to claim 14,
wherein the noise detector corresponding to each phase of the power lines on the output side or the input side of the power converter includes a capacitor and a voltage division transformer connected in series between a ground line and the corresponding power line,

a primary-side winding of the voltage division transformer has one end connected to one end of the capacitor on a side opposite to the power line, and another end connected to the ground line, and
a secondary-side winding of the voltage division transformer has one end connected to a reference line having a reference potential different from a ground potential of the ground line, and another end connected to an output terminal for outputting the adjusted voltage.

**18.** The noise filter according to claim 14,
wherein the noise detector corresponding to each phase of the power lines on the output side or the input side of the power converter includes a detection transformer having a primary-side winding interposed on the corresponding power line, and
a secondary-side winding of the detection transformer has one end connected to a reference line having a reference potential, and another end connected to an output terminal for outputting the adjusted voltage.

**19.** The noise filter according to any one of claims 14, 16, and 17,
wherein the compensation signal applicator includes a signal adjustment transformer which is the transformer, and a capacitor, and
a secondary-side winding of the signal adjustment transformer has one end connected to a ground line, and another end connected to the power line via the capacitor of the compensation signal applicator.

**20.** The noise filter according to claim 18,
wherein the compensation signal applicator includes a signal adjustment transformer which is the transformer, and a capacitor, and
a secondary-side winding of the signal adjustment transformer has one end connected to a ground line, and another end connected to the power line via the capacitor of the compensation signal applicator.

**21.** The noise filter according to claim 15,
wherein the noise detector corresponding to each line of the DC buses of the power converter includes a detection transformer having a primary-side winding interposed on the corresponding line, and
a secondary-side winding of the detection transformer has one end connected to a reference line having a reference potential, and another end connected to an output terminal for outputting the adjusted voltage.

22. The noise filter according to any one of claims 14 to 17 and 19,
wherein the noise detector detects differential mode voltage in the voltage of the electromagnetic noise.

23. The noise filter according to any one of claims 18, 20, and 21,
wherein the noise detector detects voltage proportional to differential mode current in the current of the electromagnetic noise.

FIG. 1

FIG. 2

FIG. 3

FIG. 4

FIG. 5

FIG. 6

FIG. 7

FIG.8

FIG. 9

# FIG. 10

# FIG. 11

## FIG. 12

## FIG. 13

# FIG. 14

# FIG. 15

FIG. 16

FIG. 17

FIG. 18

EP 4 489 276 A1

FIG. 19

FIG. 20

FIG. 21

FIG. 22

**FIG. 23**

**FIG. 24**

45

FIG. 25

FIG. 26

FIG. 27

FIG. 28

## FIG. 29

## FIG. 30

FIG. 31

EP 4 489 276 A1

FIG. 32

FIG. 33

## FIG. 34

## FIG. 35

## FIG. 36

# FIG. 37

EP 4 489 276 A1

## FIG. 38

## FIG. 39

| INTERNATIONAL SEARCH REPORT | International application No. |
|---|---|
| | **PCT/JP2022/008506** |

**A. CLASSIFICATION OF SUBJECT MATTER**

*H02M 1/12*(2006.01)i; *H02M 7/48*(2007.01)i
FI: H02M1/12; H02M7/48 M

According to International Patent Classification (IPC) or to both national classification and IPC

**B. FIELDS SEARCHED**

Minimum documentation searched (classification system followed by classification symbols)

H02M1/12; H02M7/48

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2019-80469 A (MITSUBISHI ELECTRIC CORP) 23 May 2019 (2019-05-23)<br>entire text, all drawings | 1-23 |
| A | WO 2021/245865 A1 (MITSUBISHI ELECTRIC CORP) 09 December 2021 (2021-12-09)<br>entire text, all drawings | 1-23 |
| A | JP 2000-201044 A (MITSUBISHI ELECTRIC CORP) 18 July 2000 (2000-07-18)<br>entire text, all drawings | 1-23 |
| A | JP 10-94244 A (OKAYAMA DAIGAKUCHO) 10 April 1998 (1998-04-10)<br>entire text, all drawings | 1-23 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **09 May 2022** | **17 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

| Patent document cited in search report | | | Publication date (day/month/year) | Patent family member(s) | Publication date (day/month/year) |
|---|---|---|---|---|---|
| JP | 2019-80469 | A | 23 May 2019 | (Family: none) | |
| WO | 2021/245865 | A1 | 09 December 2021 | (Family: none) | |
| JP | 2000-201044 | A | 18 July 2000 | (Family: none) | |
| JP | 10-94244 | A | 10 April 1998 | US 5831842 A<br>entire text, all drawings | |

International application No.

**PCT/JP2022/008506**

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5263663 B